(19) Europäisches Patentamt
European Patent Office
Office européen des brevets

(11) EP 2 484 536 A1

(12) # EUROPEAN PATENT APPLICATION
published in accordance with Art. 153(4) EPC

(43) Date of publication:
**08.08.2012 Bulletin 2012/32**

(21) Application number: **10820234.2**

(22) Date of filing: **27.07.2010**

(51) Int Cl.:
***B41N 1/14*** (2006.01) ***G03F 7/00*** (2006.01)
***G03F 7/11*** (2006.01)

(86) International application number:
**PCT/JP2010/062646**

(87) International publication number:
**WO 2011/040114 (07.04.2011 Gazette 2011/14)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **29.09.2009 JP 2009225552**

(71) Applicant: **FUJIFILM Corporation**
**Tokyo 106-0031 (JP)**

(72) Inventors:
- **MORI Takanori**
**Haibara-gun, Shizuoka (JP)**
- **HAYASHI Kenji**
**Haibara-gun, Shizuoka (JP)**

(74) Representative: **HOFFMANN EITLE**
**Patent- und Rechtsanwälte**
**Arabellastrasse 4**
**81925 München (DE)**

(54) **METHOD FOR PRODUCING PLANOGRAPHIC PRINTING PLATE PRECURSOR**

(57) To provide a method for producing a lithographic printing plate precursor excellent in development property and printing durability, which method restrains mixture of both layers at coating and drying an overcoat layer on an image-recording layer. A method for producing a polymerizable lithographic printing plate precursor including (a) a step of coating a coating solution of an image-recording layer containing (A) a sensitizing dye, (B) a radical polymerization initiator and (C) a radical polymerizable compound on a support, (b) a first drying step of supplying hot air to the image-recording layer, (c) a second drying step of supplying hot air and superheated vapor to the image-recording layer after the first drying step, (d) a step of coating an overcoat layer on the image-recording layer, and (e) a step of drying the overcoat layer.

FIG. 2

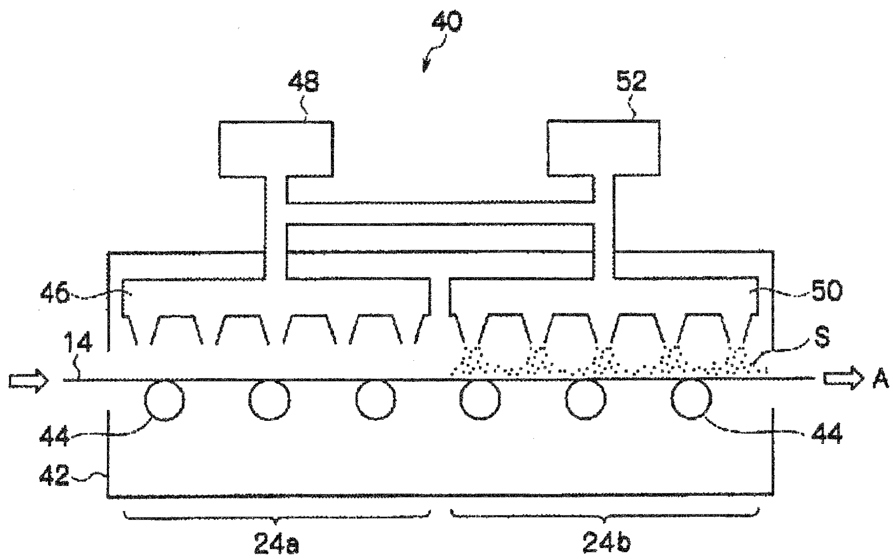


EP 2 484 536 A1

## Description

TECHNICAL FIELD

The present invention relates to a method for producing a negative lithographic printing plate precursor which is capable of undergoing image recording with laser and contains a polymerizable compound. In particularly, it relates to a method for producing a negative lithographic printing plate precursor which is capable of undergoing development with at least any of ink and dampening water on a printing machine and contains a polymerizable compound.

BACKGROUND ART

In general, a lithographic printing plate is composed of an oleophilic image area accepting ink and a hydrophilic non-image area accepting dampening water in the process of printing. Lithographic printing is a printing method utilizing the nature of water and oily ink to repel with each other and comprising rendering the oleophilic image area of the lithographic printing plate to an ink-receptive area and the hydrophilic non-image area thereof to a dampening water-receptive area (ink-unreceptive area), thereby making a difference in adherence of the ink on the surface of the lithographic printing plate, depositing the ink only to the image area, and then transferring the ink to a printing material, for example, paper.

In order to produce the lithographic printing plate, a lithographic printing plate precursor (PS plate) comprising a hydrophilic support having provided thereon an oleophilic photosensitive resin layer (image-recording layer) is used. Specifically, the PS plate is exposed through a mask, for example, a lith film, and then subjected to development processing, for example, with an alkaline developer to remove the unnecessary image-recording layer corresponding to the non-image area by dissolving while leaving the image-recording layer corresponding to the image area, thereby obtaining the lithographic printing plate.

Due to the recent progress in the technical field, nowadays the lithographic printing plate can be obtained by a CTP (computer-to-plate) technology. Specifically, a lithographic printing plate precursor is directly subjected to scanning exposure using laser or laser diode without using a lith film and developed to obtain a lithographic printing plate. In particular, there are known lithographic printing plate precursors provided with a photopolymerization type image-recording layer in which a polymerizable compound is polymerized or crosslinked and they ordinarily have an overcoat layer on the image-recording layer in order to block oxygen which inhibits the polymerization.

As to the lithographic printing plate precursor in which the overcoat layer is laminated on the image-recording layer, at the stage of coating and drying the overcoat layer on the image recording layer the image-recording layer and overcoat layer are mixed and the components which should be contained in the image-recording layer move to the overcoat layer so that the functions which the image-recording layer should intrinsically have are impaired to cause deterioration of development property or deterioration of printing durability. Also, the components which should be contained in the overcoat layer move to the image-recording layer to cause deterioration of ink receptivity and deterioration of printing durability.

As a means of restraining the mixture described above, it has been conducted to shorten a period until the overcoat layer is dried, for example, by reducing the amount of coating solution or strengthening the drying condition. However, it cannot go far enough to obtain a sufficient effect because of restriction on coating aptitude in the production.

The method of strengthening the drying condition described above has problems in that the layer is totally densified and in that heat reaction of the drying object occurs throughout the layer.

Therefore, a means which can efficiently remove the residual solvent in the drying object to be dried without deterioration of the performance of the drying object and can more accelerate the densification of surface to restrain the mixture of respective layers has been earnestly desired.

As the drying technique, although a method of using dry hot air is common, various proposals have been made on drying methods using hot air containing solvent vapor.

For instance, an apparatus for continuously drying a drying object containing moisture using superheated steam is proposed in Patent Document 1. Also, an apparatus for drying and processing food using superheated steam is proposed in Patent Document 2.

Also, a proposal on a steam dryer for removing with accuracy water droplet and other contaminations from device parts using vapor of a flammable solvent, for example, isopropyl alcohol or an equivalent low ignition point solvent is made in Patent Document 3 or 4.

Also, as a method for removing a residual solvent in a coated layer, a method proposed based on theoretical analysis by Vrentas et al. (J. Appl. Polym. Sci., 30, 4499 (1985)) is described in Patent Document 5. Vrentas et al. discloses that the factors which make it difficult to remove a high boiling point solvent or the like remaining in a polymer resin are that as an amount of the solvent remaining in the polymer resin decreases, a diffusion coefficient of the solvent in the polymer resin becomes drastically smaller and that the diffusion coefficient of the solvent in the polymer resin

becomes small as a size (molar molecular volume) of the solvent molecule per se increases.
Specifically, it is proposed by Vrentas et al. that 1) a polymer resin layer containing an extremely small amount of a high boiling point solvent is heated with exposing to vapor of a solvent having the molar molecular volume smaller than that of the high boiling point solvent and 2) the polymer resin layer is taken from atmosphere of the second solvent vapor and heated.
Also, it is described in Patent Document 6 that in a photopolymer type photosensitive lithographic printing plate precursor having an overcoat layer (overcoat layer or oxygen permeability-controlling layer) coated as the uppermost layer, after drying in an overcoat layer drying zone, drying is carried out while compensating moisture to the overcoat layer by supplying superheated vapor, cooling is conducted and the moisture content in the layer is controlled in a humidity control step.

PRIOR ART DOCUMENT

PATENT DOCUMENT

Patent Document 1: JP-T-9-502252
Patent Document 2: JP-A-2002-333275
Patent Document 3: JP-T-2000-516334
Patent Document 4: JP-A-2002-367950
Patent Document 5: JP-A-2000-158814
Patent Document 6: JP-A-2009-86343

DISCLOSURE OF THE INVENTION

PROBLEMS THAT THE INVENTION IS TO SOLVE

According to conventional hot air drying, in a lithographic printing plate precursor comprising a support having laminated thereon an image-recording layer containing a polymerizable compound and an overcoat layer in this order, a drawback arises in that at the stage of coating and drying the overcoat layer on the image recording layer the image-recording layer and overcoat layer are mixed. For example, in a case where the overcoat layer contains polyvinyl alcohol, when a solvent is dried off according to a conventional drying method (with heat air having temperature of 100°C or higher and dew point of 5 to 20°C) of an image recording layer, hydrophilic polyvinyl alcohol is mixed into the image-recording layer so that curing of the image recording layer upon exposure becomes insufficient to cause deterioration of printing durability. Also, in a case where the overcoat layer contains mica, deterioration of ink receptivity caused by the mica mixed into the image-recording layer occurs. Such problems can be inhibited by thoroughly performing the hot air drying of the image-recording layer but a drawback arises in that the state of image-recording layer changes to cause inferior quality.
Thus, a means which can efficiently remove the residual solvent in the image-recording layer to be dried without deterioration of the performance of the image-recording layer and can more accelerate the densification of surface to restrain the mixture of respective layers has been earnestly desired.
The present invention has be made in view of such circumstances and it is an object of the present invention to provide a lithographic printing plate precursor in which the residual solvent in the image-recording layer is efficiently removed to be dried and the densification of surface of the image-recording layer is more accelerated to restrain the mixture with the overcoat layer and which is excellent in development property and printing durability.

MEANS FOR SOLVING THE PROBLEMS

1. A method for producing a polymerizable lithographic printing plate precursor comprising (a) a step of coating a coating solution of an image-recording layer containing (A) a sensitizing dye, (B) a radical polymerization initiator and (C) a radical polymerizable compound on a support, (b) a first drying step of supplying hot air to the image-recording layer, (c) a second drying step of supplying hot air and superheated vapor to the image-recording layer after the first drying step, (d) a step of coating an overcoat layer on the image-recording layer, and (e) a step of drying the overcoat layer.
2. The method for producing a lithographic printing plate precursor as described in the above-mentioned 1, wherein

a supplying time of the superheated vapor is from 0.25 to 15 seconds.

3. The method for producing a lithographic printing plate precursor as described in the above-mentioned 1 or 2, wherein a supplying amount of the superheated vapor is from 50 to 500 $g/m^3$.

4. The method for producing a lithographic printing plate precursor as described in the above-mentioned 3, wherein a supplying amount of the superheated vapor is from 100 to 400 $g/m^3$.

5. The method for producing a lithographic printing plate precursor as described in any one of the above-mentioned 1 to 4, wherein when surface temperature of the image-recording layer is T (°C), an amount H ($g/m^3$) of the superheated vapor supplied complies with formula: H < 0.016 x T ^ 2.2 (wherein ^ represents an exponentiation).

6. The method for producing a lithographic printing plate precursor as described in any one of the above-mentioned 1 to 5, wherein the image-recording layer is an image-recording layer which is capable of forming an image after image exposure by supplying at least any of printing ink and dampening water on a printing machine to remove an unexposed area.

7. The method for producing a lithographic printing plate precursor as described in any one of the above-mentioned 1 to 6, wherein the overcoat layer contains a water-soluble polymer.

8. The method for producing a lithographic printing plate precursor as described in the above-mentioned 7, wherein the water-soluble polymer in the overcoat layer is polyvinyl alcohol.

9. The method for producing a lithographic printing plate precursor as described in any one of the above-mentioned 1 to 8, wherein the overcoat layer contains a stratiform compound.

10. The method for producing a lithographic printing plate precursor as described in the above-mentioned 9, wherein the stratiform compound in the overcoat layer is mica.

According to the invention, the object can be achieved by a method for producing a lithographic printing plate precursor comprising steps (a) to (e) described above. Specifically, according to the invention, the mixture of overcoat layer can be restrained by means that after coating a coating solution of an image-recording layer containing a polymerizable compound on a support, the image-recording layer is dried with hot air in the first drying step and further dried by supplying hot air and superheated vapor to the image-recording layer in the second drying step. Although the reason for the effect of restraining the mixture between layers by the superheated vapor is not quite clear, it is estimated that only the surface of the image-recording layer is densified because a large variation is not found in the amount of residual solvent in the image-recording layer. The reason for restraining the mixture of overcoat layer is estimated to be that as well as the efficient drying and removal of high boiling point solvent in the drying object, the densification of the surface can be performed.

## ADVANTAGE OF THE INVENTION

According to the constitution of the invention, the development property can be improved without degradation of the printing durability, in particular, the on-press development property of a lithographic printing pate precursor which enables removing an unexposed area of the image-recording layer with at least any on ink and dampening water on a printing machine can be improved.

## BRIEF DESCRIPTION OF DRAWINGS

Fig. 1 is a schematic view showing an example of a production line 10 of a lithographic printing plate precursor according to the invention.

Fig. 2 is a schematic view showing an example of a constitution of a drying apparatus 40 applied to the invention.

## MODE FOR CARRYING OUT THE INVENTION

The method for producing a lithographic printing plate precursor according to the invention comprises (a) a step of coating a coating solution of an image-recording layer containing (A) a sensitizing dye, (B) a radical polymerization initiator and (C) a radical polymerizable compound on a support, (b) a first drying step of supplying hot air to the image-recording layer, (c) a second drying step of supplying hot air and superheated vapor to the image-recording layer after the first drying step, (d) a step of coating an overcoat layer on the image-recording layer, and (e) a step of drying the overcoat layer.

The term "superheated vapor" as used herein may mean superheated steam or may mean a mixture of superheated steam and other gas.

A preferred embodiment of the method for producing a lithographic printing plate precursor according to the

invention will be described below with reference to the accompanying drawings. Fig. 1 illustrates an example of a production line 10 of a lithographic printing plate precursor according to the invention and the description will be made below along the example of a production line 10.

[Coating and drying of image-recording layer]

In an image-recording layer coating unit 22, a coating solution of a radical polymerization type photosensitive composition is coated. In an image-recording layer drying unit 24, the coating solution of a radical polymerization type photosensitive composition coated is dried to form an image-recording layer. Details of the coating and drying of image-recording layer will be described below.

The image-recording layer according to the invention is formed by dispersing or dissolving each of the necessary constituting components described above in a known solvent to prepare a coating solution and coating the solution on a support by a known method, for example, a method of using a coating rod, a method of using an extrusion type coater or a method of using a slide bead coater as described in Paragraph Nos. [0142] to [0143] of JP-A-2008-195018.

As to the support 14 on which the image-recording layer has been coated, drying of the image-recording layer is conducted in the image-recording layer drying unit 24. According to the invention, the image-recording layer drying unit 24 is composed of at least a first drying unit 24a and a second drying unit 24b. In the first drying unit 24a which constitutes a front half part of the image-recording layer drying unit 24, the image-recording layer is dried by hot air. In the first drying unit 24a, it is desired that the drying object is dried up to a drying point. The drying point as used herein means a point of dry status where change in surface gloss of the drying object formed by coating the coating solution is not observed in the drying process. Specifically, it means a critical point at which the drying status shifts from a constant rate drying period to a reducing rate drying period and a point at which the solid content amount becomes in a range from 70 to 90% by weight.

In the second drying unit 24b which constitutes a latter half part of the image-recording layer drying unit 24, the image-recording layer is dried by hot air and superheated vapor. In accordance with drying by heating with supplying the superheated vapor in the second drying unit 24b, only the surface of the image-recording layer is densified so that mixture of the image-recording layer and overcoat layer in an overcoat layer coating and drying unit can be restrained without accompanying quality degradation of the image-recording layer due to applying an excess amount of heat to the surface of lithographic printing plate precursor.

Fig. 2 is a drawing for illustrating an example of a constitution of a drying apparatus 40 applied to the invention. As shown in Fig. 2, the drying apparatus 40 has a drying box 42 formed along with the conveyance direction of the support 14, and slit-shaped openings for entering and leaving the support 14 are formed at both ends of the drying box. At the inside of the drying box 42, a plurality of pass roller 44 is disposed for conveying the support 14.
The drying box 42 is constituted by the first drying unit 24a which blows hot air onto the support 14 to dry it and the second drying unit 24b which blows hot air including superheated vapor onto the support 14 to dry it. In Fig. 2, an arrow A indicates the conveyance direction of the support 14.

In the first drying unit 24a, a plurality of nozzles 46 for blowing hot air onto the support 14 is disposed in the upper part of the drying box 42. The nozzles 46 are connected to a hot air generator 48 via piping. This enables to blow hot air onto the support 14 for drying in the first drying unit 24a.
In the second drying unit 24b, a plurality of nozzles 50 for blowing hot air and superheated vapor onto the support 14 are disposed in the upper part of the drying box 42. The nozzles 50 are connected to a hot air generator 48 and to a superheated vapor generator 52 via piping. This enables to blow hot air and superheated vapor S onto the support 14 for drying in the second drying unit 24b. The number of nozzles 46 and the number of nozzles 50 and the place for disposing them are not limited to the example of Fig. 2. Further, in the example of the drying apparatus 40, the nozzles 46 and nozzles 50 are connected to the same hot air generator 48, and the same hot air is supplied to the first drying unit 24a and the second drying unit 24b. Different hot air generators may be provided for the first drying unit 24a and the second drying unit 24b. Providing different hot air generators enables to differentiate drying conditions (for example, temperature of hot air or air volume) for the first drying unit 24a and the second drying unit 24b.

The term "hot air" means air having temperature ranging from 60 to 200°C and humidity ranging from 0 to 3% RH. The air volume is preferably in a range from 0.1 to 30 m/sec.

The superheated vapor is blown from the nozzles 50 onto the image-recording layer and the supplying time of the superheated vapor is preferably from 0.25 to 15 seconds. When the supplying time is 0.25 seconds or longer, the heating and drying of the image-recording layer by superheated vapor is sufficient to certainly achieve the desired effects. Also, drying unevenness in the layer can be reduced to lead to stability of the performance. Further, when the supplying time is 15 seconds or shorter, since the excess amount of superheated vapor is not supplied onto the surface of the image-recording layer, dark polymerization in the image-recording layer is restrained and as a result, the development property is improved.

The supplying amount of superheated vapor is preferably from 50 to 500 g/$m^3$, and more preferably from 100

to 400 g/$m^3$. When the supplying amount of superheated vapor is 50 g/$m^3$ or more, the heating and drying of the image-recording layer by superheated vapor is sufficient to certainly achieve the desired effects. Also, drying unevenness in the layer can be reduced to lead to stability of the performance. Further, when the supplying amount of superheated vapor is 500 g/$m^3$ or less, since the excess amount of superheated vapor is not supplied onto the surface of the image-recording layer, dark polymerization in the image-recording layer is restrained and as a result, the development property is improved.

In the method for producing a lithographic printing plate precursor according to the invention, it is preferred that when surface temperature of the image-recording layer is T (°C), an amount H (g/$m^3$) of the superheated vapor supplied complies with formula: $H < 0.016 \times T ^ 2.2$ (wherein ^ represents an exponentiation). Condensation of the vapor on the drying object contributes to the degradation of functions of the drying object, for example, a functional material. Defining the amount of vapor as described above enables restraining dew condensation of the vapor on the drying obj ect and increasing drying efficiency under the vapor atmosphere.

In Fig. 2, the first drying unit 24a and the second drying unit 24b are placed in the drying box 42. As another embodiment, the first drying unit 24a and the second drying unit 24b may be placed separately in different drying boxes. Also, it is possible to prevent allowing the hot air and the superheated vapor to mix each other between the first drying unit 24a and the second drying unit 24b by means of providing a partition plate, an air curtain or the like between the first drying unit 24a and the second drying unit 24b in the drying box 42.

As a specific example, the drying system of the image-recording layer according to the invention is described below. The support 14 having the image-recording layer coated is conveyed through the slit-shaped opening into the drying box 42 of the drying apparatus 40, and while being supported by the pass rollers 44 from its lower surface, moves in the drying apparatus 40. In the first drying unit 24a, hot air is blown toward the image-recording layer on the support 14 from the plurality of nozzles 46. Subsequently, in the drying box 42, the support 14 is carried from the first drying unit 24a into the second drying unit 24b by the pass rollers 44. In the second drying unit 24b, hot air including superheated vapor S is blown toward the image-recording layer on the support 14 from the plurality of nozzles 50.

[Content of image-recording layer]

The constituting components of the image-recording layer will be described in detail below.
The image-recording layer for use in the invention is preferably an image-recording layer capable of undergoing on-press development. As a representative image-forming embodiment capable of undergoing on-press development which the image-recording layer includes, (1) an embodiment which contains (A) a sensitizing dye, (B) a radical polymerization initiator and (C) a radical polymerizable compound and in which the image area is cured utilizing a polymerization reaction is exemplified and, for example, (D) a hydrophobilizing precursor may be incorporated into the image-recording layer of radical polymerization type (1). It is particularly effective in the case of using an infrared absorbing dye as the sensitizing dye.
Respective components which can be incorporated into the image-recording layer will be described in order below.

(A) Sensitizing dye

The sensitizing dye for use in the image-recording layer according to the invention can be used without particular limitation as far as it absorbs light at the image exposure to form the excited state and provides energy to a polymerization initiator described hereinafter with electron transfer, energy transfer or heat generation thereby improving the polymerization initiation function. In particular, a sensitizing dye having an absorption maximum in a wavelength range from 300 to 450 nm or from 750 to 1,400 nm is preferably used.

Examples of the sensitizing dye having an absorption maximum in a wavelength range from 300 to 450 nm include a merocyanine dye, a benzopyran, a coumarin, an aromatic ketone and an anthracene.

Of the sensitizing dyes having an absorption maximum in a wavelength range from 300 to 450 nm, a dye represented by formula (I) shown below is more preferred in view of high sensitivity.

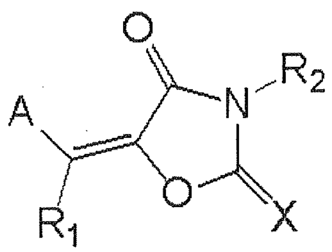

(I)

In formula (I), A represents an aromatic cyclic group which may have a substituent or a heterocyclic group which may have a substituent, X represents an oxygen atom, a sulfur atom or N-($R_3$), and $R_1$, $R_2$ and $R_3$ each independently represents a monovalent non-metallic atomic group, or A and $R_1$ or $R_2$ and $R_3$ may be combined with each other to form an aliphatic or aromatic ring.

The formula (I) will be described in more detail below. $R_1$, $R_2$ and $R_3$ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom.

Now, A in formula (I) is described below. A represents an aromatic cyclic group which may have a substituent or a heterocyclic group which may have a substituent. Specific examples of the aromatic cyclic group which may have a substituent and heterocyclic group which may have a substituent are same as those described for any one of $R_1$, $R_2$ and $R_3$ in formula (I), respectively.

As specific examples of the sensitizing dye, compounds described in Paragraph Nos. [0047] to [0053] of JP-A-2007-58170 are preferably used.

Further, sensitizing dyes represented by formulae (II) to (III) shown below can also be used.

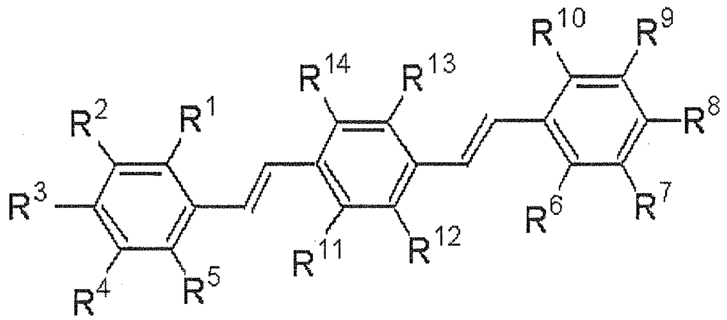

(II)

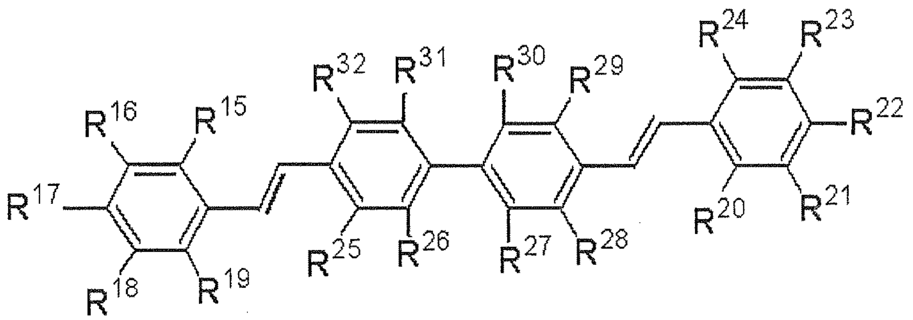

(III)

In formula (II), $R^1$ to $R^{14}$ each independently represents a hydrogen atom, an alkyl group, an alkoxy group, a cyano group or a halogen atom, provided that at least one of $R^1$ to $R^{10}$ represents an alkoxy group having 2 or more carbon atoms.

In formula (III), $R^{15}$ to $R^{32}$ each independently represents a hydrogen atom, an alkyl group, an alkoxy group, a cyano group or a halogen atom, provided that at least one of $R^{15}$ to $R^{24}$ represents an alkoxy group having 2 or more carbon atoms.

Further, sensitizing dyes described in JP-A-2007-171406, JP-A-2007-206216, JP-A-2007-206217, JP-A-2007-225701, JP-A-2007-225702, JP-A-2007-316582 and JP-A-2007-328243 are also preferably used.

Next, the sensitizing dye having an absorption maximum in a wavelength range from 750 to 1,400 (hereinafter, also referred to as an "infrared absorbing agent") preferably used in the invention is described in detail below. The infrared absorbing agent used is preferably a dye or pigment.

The infrared absorbing dye has a function of converting the infrared ray absorbed to heat and a function of being excited by the infrared ray to perform electron transfer and/or energy transfer to a radical polymerization initiator described hereinafter. The infrared absorbing dye for use in the invention is a dye having an absorption maximum in a wavelength range from 750 to 1,400 nm.

As the infrared absorbing dye, compounds described in Paragraph Nos. [0058] to [0087] of JP-A-2008-195018 can be used.

Of the dyes, a dye, a squarylium dye, a pyrylium dye and a nickel thiolate complexes are particularly preferred. As the particularly preferred example of the dye, a cyanine dye represented by formula (a) shown below is exemplified.

Formula (a)

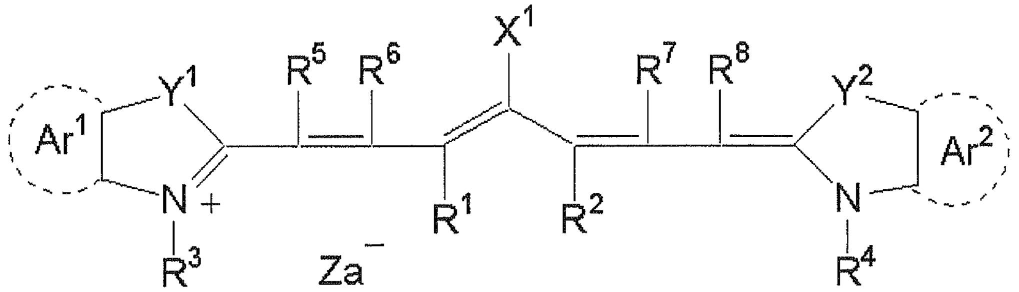

In formula (a), $X^1$ represents a hydrogen atom, a halogen atom, $-N(R^9)$ $(R^{10})$, $X^2$-$L^1$ or a group shown below. $R^9$ and $R^{10}$, which may be the same or different, each represents an aromatic hydrocarbon group having from 6 to 10 carbon atoms, which may have a substituent, an alkyl group having from 1 to 8 carbon atoms, which may have a substituent or a hydrogen atom, or $R^9$ and $R^{10}$ may be combined with each other to form a ring. Among them, a phenyl group is preferred. $X^2$ represents an oxygen atom or a sulfur atom, $L^1$ represents a hydrocarbon group having from 1 to 12 carbon atoms, an aromatic ring group containing a hetero atom or a hydrocarbon group having from 1 to 12 carbon atoms and containing a hetero atom. The hetero atom as used herein indicates a nitrogen atom, a sulfur atom, an oxygen atom, a halogen atom or a selenium atom. In the group shown below, $Xa^-$ has the same meaning as $Za^-$ defined hereinafter, and $R^a$ represents a hydrogen atom or a substituent selected from an alkyl group, an aryl group, a substituted or unsubstituted amino group and a halogen atom.

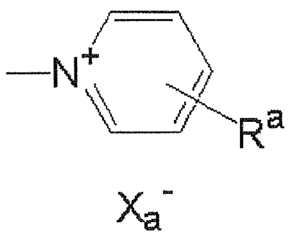

$R^1$ and $R^2$ each independently represents a hydrocarbon group having from 1 to 12 carbon atoms. In view of the preservation stability of a coating solution for image-recording layer, it is preferred that $R^1$ and $R^2$ each represents a hydrocarbon group having two or more carbon atoms. It is particularly preferred that $R^1$ and $R^2$ are combined with each other to form a 5-membered or 6-membered ring.

$Ar^1$ and $Ar^2$, which may be the same or different, each represents an aromatic hydrocarbon group which may have a substituent. Preferred examples of the aromatic hydrocarbon group include a benzene ring group and a naphthalene ring group. Also, preferred examples of the substituent include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms, which may have a substituent. Preferred examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (a) has an anionic substituent in the structure thereof and neutralization of charge is not needed. In view of the preservation stability of a coating solution for image-recording layer, preferred examples of the counter ion for $Za^-$ include a halide ion, a perchlorate ion, a tetrafluoroborate ion, a hexafluorophosphate ion and a sulfonate ion, and particularly preferred examples thereof include a perchlorate ion, a hexafluorophosphate ion and an arylsulfonate ion.

Specific examples of the cyanine dye represented by formula (a), which can be preferably used in the invention, include those described in Paragraph Nos. [0017] to [0019] of JP-A-2001-133969, Paragraph Nos. [0012] to [0021] of JP-A-2002-23360 and Paragraph Nos. [0012] to [0037] of JP-A-2002-40638.

The infrared absorbing dye (A) may be used only one kind or in combination of two or more kinds thereof and it may also be used together with an infrared absorbing agent other than the infrared absorbing dye, for example, a pigment. As the pigment, compounds described in Paragraph Nos. [0072] to [0076] of JP-A-2008-195018 are preferred.
The content of the sensitizing dye in the image-recording layer according to the invention is preferably from 0.1 to 10.0% by weight, more preferably from 0.5 to 5.0% by weight, based on the total solid content of the image-recording layer.

(B) Radical polymerization initiator

The radical polymerization initiator (B) for use in the invention indicates a compound which initiates or accelerates polymerization of a radical polymerizable compound (C). The radical polymerization initiator for use in the invention includes, for example, known thermal polymerization initiators, compounds containing a bond having small bond dissociation energy and photopolymerization initiators.
The radical polymerization initiator according to the invention include, for example, (a) an organic halide, (b) a carbonyl compound, (c) an azo compound, (d) an organic peroxide, (e) a metallocene compound, (f) an azide compound, (g) a hexaarylbiimidazole compound, (h) an organic borate compound, (i) a disulfone compound, (j) an oxime ester compound and (k) an onium salt compound.
As the organic halide (a), compounds described in Paragraph Nos. [0022] to [0023] of JP-A-2008-195018 are preferred.
As the carbonyl compound (b), compounds described in Paragraph No. [0024] of JP-A-2008-195018 are preferred.
As the azo compound (c), for example, azo compounds described in JP-A-8-108621 are used.
As the organic peroxide (d), for example, compounds described in Paragraph No. [0025] of JP-A-2008-195018 are preferred.
As the metallocene compound (e), for example, compounds described in Paragraph No. [0026] of JP-A-2008-195018 are preferred.
As the azide compound (f), a compound, for example, 2,6-bis(4-azidobenzylidene)-4-methylcyclohexanone is exemplified.
As the hexaarylbiimidazole compound (g), for example, compounds described in Paragraph No. [0027] of JP-A-2008-195018 are preferred.
As the organic borate compound (h), for example, compounds described in Paragraph No. [0028] of JP-A-2008-195018 are preferred.
As the disulfone compound (i), for example, compounds described in JP-A-61-166544 and JP-A-2002-328465 are exemplified.
As the oxime ester compound (j), for example, compounds described in Paragraph Nos. [0028] to [0030] of JP-A-2008-195018 are preferred.
As the onium salt compound (k), onium salts, for example, diazonium salts described in S. I. Schlesinger, Photogr. Sci. Eng., 18, 387 (1974) and T. S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848 and JP-A-2008-195018, sulfonium salts described in European Patents 370,693, 390,214, 233,567, 297,443 and 297,442, U.S. Patents 4,933,377, 4,760,013, 4,734,444 and 2,833,827 and German Patents 2,904,626, 3,604,580 and 3,604,581, selenonium salts described in J. V. Crivello et al., Macromolecules, 10 (6), 1307 (1977) and J. V. Crivello et al., J. Polymer Sci., Polymer Chem. Ed., 17, 1047 (1979), arsonium salts described in C. S. Wen et al., Teh, Proc. Conf. Rad. Curing ASIA, p. 478, Tokyo, Oct. (1988), and azinium salts described in JP-A-2008-195018 are exemplified.
Of the radical polymerization initiators described above, the onium salt, in particular, the iodonium salt, the sulfonium salt or the azinium salt is more preferred. Specific examples of these compounds are set forth below, but the invention should not be construed as being limited thereto.
Of the iodonium salts, a diphenyliodonium salt is preferred. In particular, a diphenyliodonium salt substituted with an electron donating group, for example, an alkyl group or an alkoxy group is preferred, and an asymmetric diphenyliodonium salt is more preferred. Specific examples of the iodonium salt include diphenyliodonium hexafluorophosphate, 4-methoxyphenyl-4-(2-methylpropyl)phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate and bis(4-tert-butylphenyl)iodonium tetraphenylborate.
Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate and tris(4-chlorophenyl)sulfonium 3,5-bis(methoxycarbonyl)benzenesulfonate.

Examples of the azinium salt include 1-cyclohexylmethyloxypyridinium hexafluorophosphate, 1-cyclohexyloxy-4-phenylpyridinium hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate.

The radical polymerization initiator can be added preferably in an amount from 0.1 to 50% by weight, more preferably from 0.5 to 30% by weight, particularly preferably from 0.8 to 20% by weight, based on the total solid content constituting the image-recording layer. In the range described above, good sensitivity and good stain resistance in the non-image area at the time of printing are obtained.

(C) Radical polymerizable compound

The radical polymerizable compound (C) for use in the invention is an addition-polymerizable compound having at least one ethylenically unsaturated double bond, and it is preferably selected from compounds having at least one, preferably two or more, terminal ethylenically unsaturated double bonds. Such compounds are widely known in the field of art and they can be used in the invention without any particular limitation. These mean, for example, a monomer, a prepolymer, specifically, a dimer, a trimer or an oligomer, and are polymerizable compounds having a molecular weight of 1,000 or less.

Specific examples of the radical polymerizable compound include compounds described in Paragraph Nos. [0089] to [0098] of JP-A-2008-195018. Among them, esters of aliphatic polyhydric alcohol compound with an unsaturated carboxylic acid (for example, acrylic acid, methacrylic acid, itaconic acid, crotonic acid, isocrotonic acid or maleic acid) are preferably exemplified. Other preferred radical polymerizable compounds include polymerizable compounds containing an isocyanuric acid structure described in JP-A-2005-329708.

Of the compounds described above, isocyanuric acid ethylene oxide-modified acrylates, for example, tris(acryloyloxyethyl) isocyanurate or bis(acryloyloxyethyl)hydroxyethyl isocyanurate are particularly preferred, because they are excellent in balance between hydrophilicity relating to the on-press development property and polymerization ability relating to the printing durability.

In the invention, the radical polymerizable compound (C) is preferably used in an amount from 5 to 80% by weight, more preferably from 15 to 75% by weight, based on the total solid content of the image-recording layer.

(D) Hydrophobilizing precursor

According to the invention, a hydrophobilizing precursor can be used particularly in order to improve the on-press development property. The hydrophobilizing precursor for use in the invention is a fine particle capable of converting the image-recording layer to be hydrophobic when heat is applied. The fine particle is preferably at least one fine particle selected from hydrophobic thermoplastic polymer fine particle, thermo-reactive polymer fine particle, microcapsule having a hydrophobic compound encapsulated and microgel (crosslinked polymer fine particle). Among them, polymer fine particle having a polymerizable group and microgel are preferred.

As the hydrophobic thermoplastic polymer fine particle, hydrophobic thermoplastic polymer fine particles described, for example, in Research Disclosure, No. 333003, January (1992), JP-A-9-123387, JP-A-9-131850, JP-A-9-171249, JP-A-9-171250 and European Patent 931,647 are preferably exemplified.

Specific examples of the polymer constituting the polymer fine particle include a homopolymer or copolymer of a monomer, for example, ethylene, styrene, vinyl chloride, methyl acrylate, ethyl acrylate, methyl methacrylate, ethyl methacrylate, vinylidene chloride, acrylonitrile, vinyl carbazole or an acrylate or methacrylate having a polyalkylene structure and a mixture thereof. Among them, polystyrene, a copolymer containing styrene and acrylonitrile or polymethyl methacrylate is more preferred.

The average particle size of the hydrophobic thermoplastic polymer fine particle for use in the invention is preferably from 0.01 to 2.0 μm.

The thermo-reactive polymer fine particle for use in the invention includes a polymer fine particle having a thermo-reactive group and forms a hydrophobilized region by crosslinkage due to thermal reaction and change in the functional group involved therein.

As the thermo-reactive group of the polymer fine particle having a thermo-reactive group for use in the invention, a functional group performing any reaction can be used as long as a chemical bond is formed. For instance, an ethylenically unsaturated group (for example, an acryloyl group, a methacryloyl group, a vinyl group or an allyl group) performing a radical polymerization reaction, a cationic polymerizable group (for example, a vinyl group or a vinyloxy group), an

isocyanate group or a blocked form thereof, an epoxy group or a vinyloxy group performing an addition reaction and a functional group having an active hydrogen atom (for example, an amino group, a hydroxy group or a carboxyl group) as the reaction partner thereof, a carboxyl group performing a condensation reaction and a hydroxy group or an amino group as the reaction partner thereof, and an acid anhydride performing a ring opening addition reaction and an amino group or a hydroxy group as the reaction partner thereof are preferably exemplified.

As the microcapsule for use in the invention, microcapsule having all or part of the constituting components of the image-recording layer encapsulated as described, for example, in JP-A-2001-277740 and JP-A-2001-277742 is exemplified. The constituting components of the image-recording layer may be present outside the microcapsule. It is a preferred embodiment of the image-recording layer containing microcapsule that hydrophobic constituting components are encapsulated in the microcapsule and hydrophilic constituting components are present outside the microcapsule.

The image-recording layer according to the invention may be an embodiment containing a crosslinked resin particle, that is, a microgel. The microgel can contain a part of the constituting components of the image-recording layer inside and/or on the surface thereof. Particularly, an embodiment of a reactive microgel containing the radical polymerizable compound (C) on the surface thereof is preferred in view of the image-forming sensitivity and printing durability.

As a method of microencapsulation or microgelation of the constituting components of the image-recording layer, known methods can be used.

The average particle size of the microcapsule or microgel is preferably from 0.01 to 3.0 μm, more preferably from 0.05 to 2.0 μm, particularly preferably from 0.10 to 1.0 μm. In the range described above, good resolution and good time-lapse stability can be achieved.

The content of the hydrophobilizing precursor is preferably in a range from 5 to 90% by weight based on the total solid content of the image-recording layer.

(E) Other components

The image-recording layer according to the invention may further contain other components, if desired.

(1) Binder polymer

In the image-recording layer according to the invention, a binder polymer can be used for the purpose of improving film strength of the image-recording layer. The binder polymer which can be used in the invention can be selected from those heretofore known without restriction, and polymers having a film-forming property are preferred. Among them, an acrylic resin, a polyvinyl acetal resin or a polyurethane resin is preferred.

As the binder polymer preferred for the invention, a polymer having a crosslinkable functional group for improving film strength of the image area in its main chain or side chain, preferably in its side chain, as described in JP-A-2008-195018 is exemplified. Due to the crosslinkable functional group, crosslinkage is formed between the polymer molecules to facilitate curing.

As the crosslinkable functional group, an ethylenically unsaturated group, for example, a (meth) acryl group, a vinyl group or an allyl group or an epoxy group is preferred. The crosslinkable functional group can be introduced into the polymer by a polymer reaction or copolymerization. For instance, a reaction between an acrylic polymer or polyurethane having a carboxyl group in its side chain and glycidyl methacrylate or a reaction between a polymer having an epoxy group and a carboxylic acid containing an ethylenically unsaturated group, for example, methacrylic acid can be utilized.

The content of the crosslinkable group in the binder polymer is preferably from 0.1 to 10.0 mmol, more preferably from 1.0 to 7.0 mmol, most preferably from 2.0 to 5.5 mmol, based on 1 g of the binder polymer.

It is also preferred that the binder polymer for use in the invention further contains a hydrophilic group. The hydrophilic group contributes to impart the development property, particularly the on-press development property, in case the on-press development is conducted, to the image-recording layer. In particular, coexistence of the crosslinkable group and the hydrophilic group makes it possible to maintain compatibility between the printing durability and development property.

The hydrophilic group includes, for example, a hydroxy group, a carboxyl group, an alkylene oxide structure, an amino group, an ammonium group, an amido group, a sulfo group and a phosphoric acid group. Among them, an alkylene oxide structure containing from 1 to 9 alkylene oxide units having 2 or 3 carbon atoms is preferred. In order to introduce a hydrophilic group into the binder polymer, a monomer having the hydrophilic group is copolymerized.

In order to control the ink receptivity, an oleophilic group, for example, an alkyl group, an aryl group, an aralkyl group or an alkenyl group may be introduced into the binder polymer according to the invention. Specifically, an oleophilic group-containing monomer, for example, an alkyl methacrylate is copolymerized.

Specific examples (1) to (11) of the binder polymer for use in the invention are set forth below, but the invention should not be construed as being limited thereto. The ratio of the repeating units is indicated as a molar ratio.

(1) 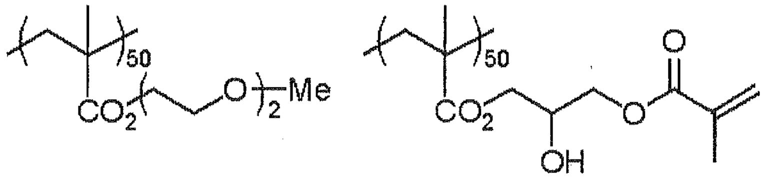

(2) 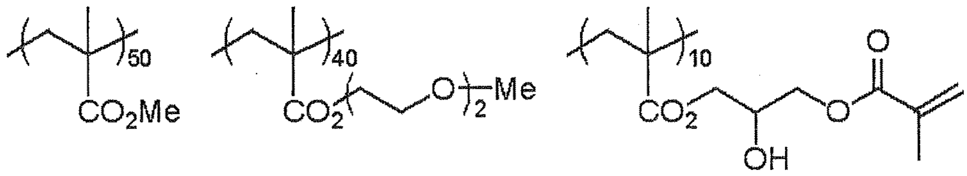

(3) 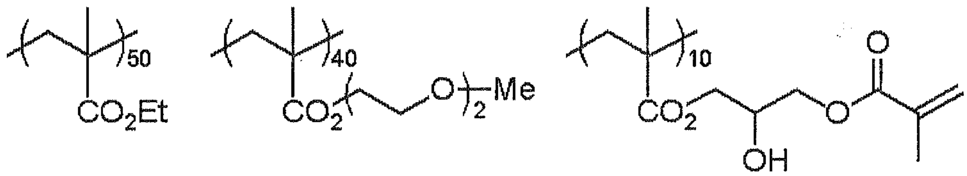

(4) 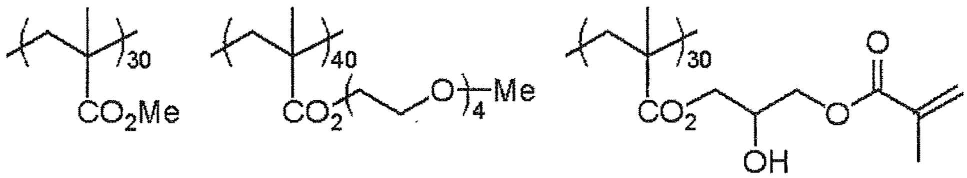

(5) 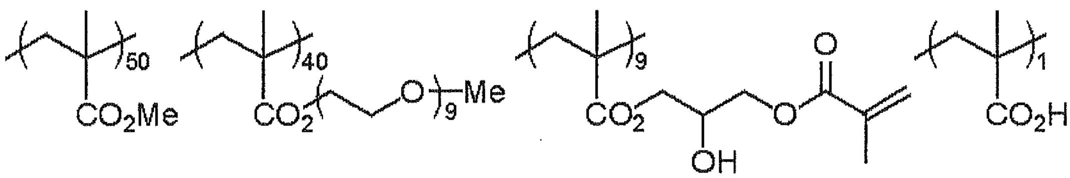

(6) 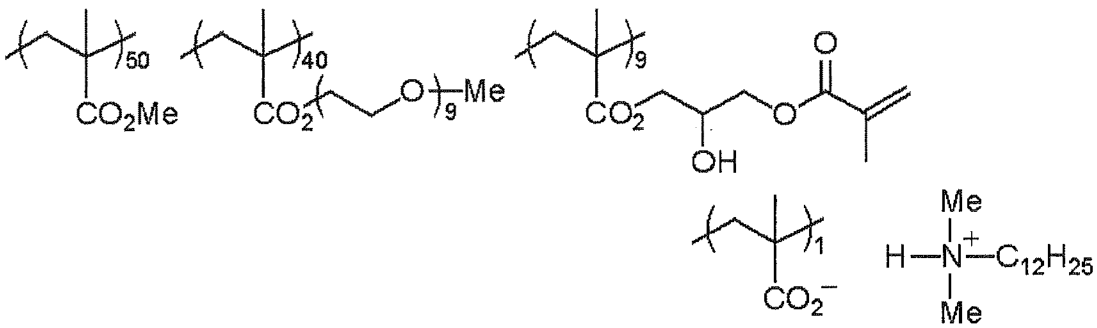

(7) 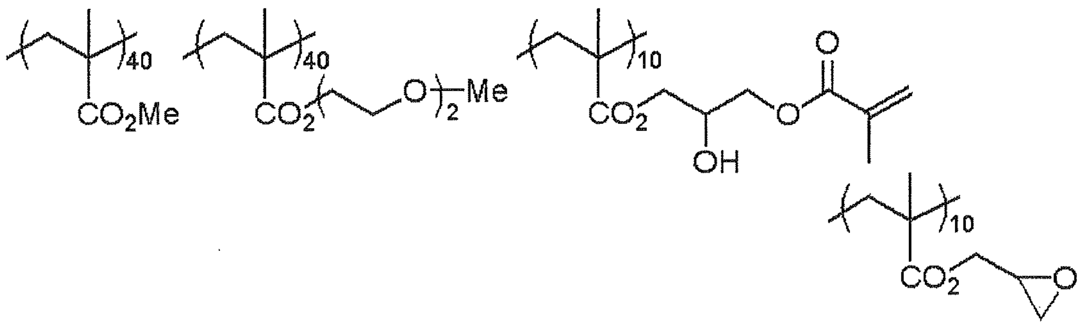

(8) 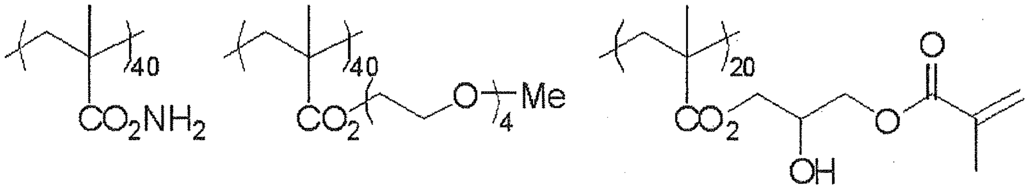

(9) 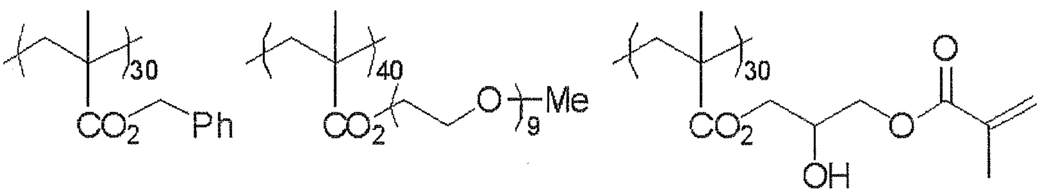

(10) 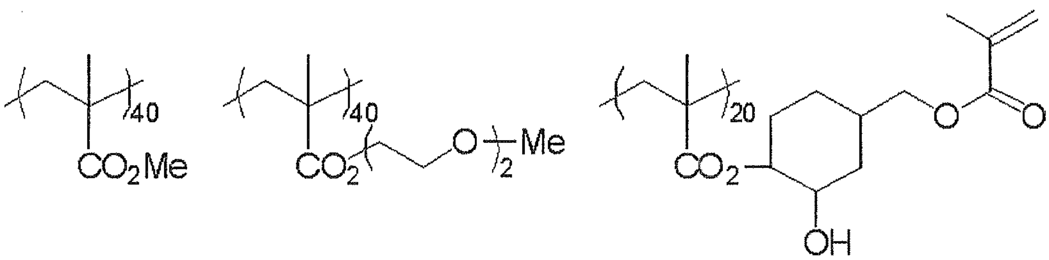

(11) 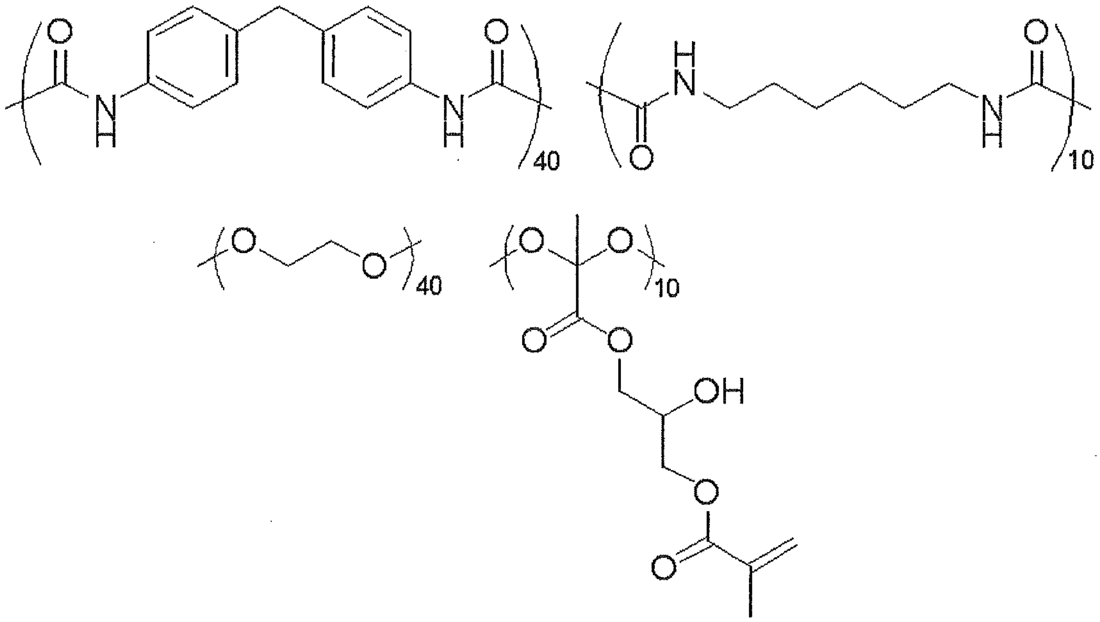

The weight average molecular weight (Mw) of the binder polymer according to the invention is preferably 2, 000 or more, more preferably 5,000 or more, and still more preferably from 10,000 to 300,000.
According to the invention, a hydrophilic polymer, for example, polyacrylic acid or polyvinyl alcohol described in JP-A-2008-195018 may be used, if desired. Further, an oleophilic binder polymer is used together with a hydrophilic binder polymer.
The content of the binder polymer is ordinarily from 5 to 90% by weight, preferably from 5 to 80% by weight, more preferably from 10 to 70% by weight, based on the total solid content of the image-recording layer.

(2) Hydrophilic low molecular weight compound

The image-recording layer according to the invention may contain a hydrophilic low molecular weight compound in order to improve the development property, particularly the on-press development property in case the on-press development is conducted, without accompanying the decrease in the printing durability.
The hydrophilic low molecular weight compound includes a water-soluble organic compound, for example, a glycol, e.g., ethylene glycol, diethylene glycol, triethylene glycol, propylene glycol, dipropylene glycol or tripropylene glycol, or an ether or ester derivative thereof, a polyhydroxy compound, e.g., glycerine, pentaerythritol or tris(2-hydroxyethyl) isocyanurate, an organic amine, e.g., triethanol amine, diethanol amine monoethanol amine, or a salt thereof, an organic sulfonic acid, e.g. , an alkyl sulfonic acid, toluene sulfonic acid or benzene sulfonic acid, or a salt thereof, an organic sulfamic acid, e.g., an alkyl sulfamic acid, or a salt thereof, an organic sulfuric acid, e.g., an alkyl sulfuric acid or an alkyl ether sulfuric acid, or a salt thereof, an organic phosphonic acid, e.g., phenyl phosphonic acid, or a salt thereof, an organic carboxylic acid, e. g. , tartaric acid, oxalic acid, citric acid, malic acid, lactic acid, gluconic acid or an amino acid, or a salt thereof and a betaine.
According to the invention, it is preferred that at least one compound selected from a polyol, an organic sulfate , an organic sulfonate and a betaine is incorporated.
Specific examples of the organic sulfonate include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetradecosane-1-sulfonate; and an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfanate, disodium 1,5-naphtyldisulfonate or trisodium 1, 3, 6-naphtyltrisulfonate. The salt may also be a potassium salt or a lithium salt.
The organic sulfate includes a sulfate of alkyl, alkenyl, alkynyl, aryl or heterocyclic monoether of polyethylene oxide. The number of ethylene oxide unit is preferably from 1 to 4. The salt is preferably a sodium salt, a potassium salt or a lithium salt.
As the betaine, a compound wherein a number of carbon atoms included in a hydrocarbon substituent on the nitrogen atom is from 1 to 5 is preferred. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptivity and printing durability of the image-recording layer can be preferably maintained.

The amount of the hydrophilic low molecular weight compound added to the image-recording layer is preferably from 0.5 to 20% by weight, more preferably from 1 to 10% by weight, still more preferably from 2 to 8% by weight, based on the total solid content of the image-recording layer. In the range described above, good on-press development property and good printing durability are achieved.

The hydrophilic low molecular weight compounds may be used individually or as a mixture of two or more thereof.

(3) Oil-sensitizing agent

In order to improve the ink receptivity, an oil-sensitizing agent, for example, a phosphonium compound, a nitrogen-containing low molecular weight compound or an ammonium group-containing polymer can be used in the image-recording layer. In particular, in the case where an inorganic stratiform compound is incorporated into an overcoat layer, the oil-sensitizing agent functions as a surface covering agent of the inorganic stratiform compound and prevents deterioration of the ink receptivity during printing due to the inorganic stratiform compound.

As preferred examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate and benzyldimethyldodecylammonium hexafluorophosphate.

The ammonium group-containing polymer may be any polymer containing an ammonium group in its structure and is preferably a polymer containing from 5 to 80% by mole of (meth) acrylate having an ammonium group in its side chain as a copolymerization component.

As to the ammonium salt-containing polymer, its reduced specific viscosity value (unit: cSt/g/ml) determined according to the measuring method described below is preferably from 5 to 120, more preferably from 10 to 110, particularly preferably from 15 to 100.

<Measuring method of reduced specific viscosity>

In a 20 ml measuring flask was weighed 3.33 g of a 30% by weight polymer solution (1 g as a solid content) and the measuring flask was filled up to the gauge line with N-methyl pyrrolidone. The resulting solution was put into an Ubbelohde viscometer (viscometer constant: 0.010 cSt/s) and a period for running down of the solution at 30°C was measured. The viscosity was determined in a conventional manner according to the following calculating formula:

Kinetic viscosity = Viscometer constant x Period for liquid to pass through a capillary (sec)

Specific examples of the ammonium group-containing polymer are set forth below.

(1) 2-(Trimethylammonio)ethyl methacrylate p-toluenesulfonate/3,6-dioxaheptyl methacrylate copolymer (molar ratio: 10/90)
(2) 2-(Trimethylammonio)ethyl methacrylate hexafluorophosphate /3,6-dioxaheptyl methacrylate copolymer (molar ratio: 20/80)
(3) 2-(Ethyldimethylammonio)ethyl methacrylate p-toluenesulfonate/hexyl methacrylate copolymer (molar ratio: 30/70)

(4) 2-(Trimethylammonio)ethyl methacrylate hexafluorophosphate /2-ethylhexyl methacrylate copolymer (molar ratio: 20/80)

(5) 2-(Trimethylammonio)ethyl methacrylate methylsulfate/hexyl methacrylate copolymer (molar ratio: 40/60)

(6) 2-(Butyldimethylammonio)ethyl methacrylate hexafluorophosphate/3,6-dioxaheptyl methacrylate copolymer (molar ratio: 20/80)

(7) 2-(Butyldimethylammonio)ethyl acrylate hexafluorophosphate/3,6-dioxaheptyl methacrylate copolymer (molar ratio: 20/80)

(8) 2-(Butyldimethylammonio)ethyl methacrylate 13-ethyl-5,8,11-trioxa-1-heptadecanesulfonate/3,6-dioxaheptyl methacrylate copolymer (molar ratio: 20/80)

(9) 2-(Butyldimethylammonio)ethyl methacrylate hexafluorophosphate/3,6-dioxaheptyl methacrylate/2-hydroxy-3-methacryloyloxypropyl methacrylate copolymer (molar ratio: 15/80/5)

The content of the oil-sensitizing agent is preferably from 0.01 to 30.0% by weight, more preferably from 0.1 to 15.0% by weight, still more preferably from 1 to 5% by weight, based on the total solid content of the image-recording layer.

(4) Other components

Other components, for example, a surfactant, a coloring agent, a print-out agent, a polymerization inhibitor, a higher fatty acid derivative, a plasticizer, a fine inorganic particle, an inorganic stratiform compound, a co-sensitizer or a chain transfer agent may further be added to the image-recording layer. Specifically, compounds and amounts added thereof described, for example, in Paragraph Nos. [0114] to [0159] of JP-A-2008-284817, Paragraph Nos. [0023] to [0027] of JP-A-2006-91479 and Paragraph No. [0060] of U.S. Patent Application Publication No. 2008/0311520 are preferably used.

[Regarding production process other than image-recording layer]

[Coating and drying of overcoat layer]

Then, in an overcoat layer coating and drying unit 26, an overcoat layer (PVA coating film) containing as the main component, a water-soluble polymer having a hydrogen bonding group, for example, PVA (polyvinyl alcohol) is formed. As to the coating method, the same coating methods as for forming the backcoat layer, undercoat layer or image-recording layer may be employed.

Examples of the water-soluble polymer having a hydrogen bonding group contained in the overcoat layer include polyvinyl alcohol, its partial ester, ether and acetal, and copolymers containing an unsubstituted vinyl alcohol unit in a substantial amount for imparting necessary water solubility to them. As the polyvinyl alcohol, those being hydrolyzed from 71 to 100% by mole and having a polymerization degree in a range from 300 to 2,400 are exemplified. Specifically, for example, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-220, PVA-224, PVA-217EE, PVA-217E, PVA-220E, PVA-224E, PVA-405, PVA-420, PVA-613 and L-8, produced by Kuraray Co., Ltd. are exemplified. As the copolymer described above, polyvinylacetatechloroacetate or propionate, polyvinylformal and polyvinylacetal and copolymers thereof each hydrolyzed from 88 to 100% by mole are exemplified. Also, a known modified polyvinyl alcohol can be preferably used. For instance, polyvinyl alcohols of various polymerization degrees having at random a various kind of hydrophilic modified cites, for example, an anion-modified cite modified with an anion, e.g., a carboxyl group or a sulfo group, a cation-modified cite modified with a cation, e.g., an amino group or an ammonium group, a silanol-modified cite or a thiol-modified cite, and polyvinyl alcohols of various polymerization degrees having at the terminal of the polymer chain a various kind of modified cites, for example, the above-described anion-modified cite, cation modified cite, silanol-modified cite or thiol-modified cite, an alkoxy-modified cite, a sulfide-modified cite, an ester modified cite of vinyl alcohol with a various kind of organic acids, an ester modified cite of the above-described anion-modified cite with an alcohol or an epoxy-modified cite are exemplified. From the standpoint of on-press development property, polyvinyl alcohol having an anion-modified cite is preferred, and polyvinyl alcohol modified with an anion of sulfo group is particularly preferred. Other useful examples of the polymer include polyvinylpyrrolidone, gelatin and gum arabic, and they may be used individually or in combination. The water-soluble polymer is preferably contained at a rate from 30 to 99% by weight, more preferably at a rate from 50 to 99%, based on the total solid content of the overcoat layer. The overcoat layer may be coated to form a plurality of layers, if desired.

Further, the overcoat layer may contain an inorganic stratiform compound. The inorganic stratiform compound is a particle having a thin tabular shape and includes, for instance, mica group, for example, natural mica or synthetic mica, talc represented by formula: $3MgO \cdot 4SiO \cdot H_2O$, taeniolite, montmorillonite, saponite, hectorite and zirconium phosphate.

It is believed that the thin tabular shape particles are dispersed in a binder in a manner of overlapping each other to form a thin layer composed of the inorganic compound in the binder containing PVA as the main component, thereby further improving water resistance, oxygen blocking property and film strength.

In the mica group described above, as the natural mica, muscovite, paragonite, phlogopite, biotite and lepidolite are exemplified. Also, as the synthetic mica, non-swellable mica, for example, fluorphlogopite $KMg_3(AlSi_3O_{10})F_2$ or potassium tetrasilicic mica $KMg_{2.5}(Si_4O_{10})$ $F_2$, and swellable mica, for example, Na tetrasilicic mica $NaMg_{2.5}(Si_4O_{10})F_2$, Na or Li taeniolite (Na, Li)$Mg_2Li(Si_4O_{10})F_2$, or montmorillonite-based Na or Li hectorite $(Na, Li)_{1/8}Mg_{2/5}Li_{1/8}(Si_4O_{10})F_2$ are exemplified. Further, synthetic smectite is also useful.

The mica compound is preferred and the amount thereof in case of adding to the overcoat layer is preferably in a range from 1.0 to 30% by weight, more preferably in a range from 2.0 to 20% by weight, based on the total solid content of the overcoat layer.

Also, the overcoat layer may contain an organic resin fine particle. The organic resin fine particle which has high affinity with a binder (for example, polyvinyl alcohol) of the overcoat layer, is thoroughly kneaded in the overcoat layer and do not separate from the surface of the overcoat layer is preferred.

Examples of the organic resin fine particle having the characteristics described above include fine particle of synthetic resin, for example, a poly(meth)acrylate, polystyrene and its derivative, a polyamide, a polyimide, a polyolefin, for example, low density polyethylene, high density polyethylene or polypropylene and a copolymer thereof with poval, a polyurethane, a polyurea or a polyester, and fine particle of natural polymer, for example, chitin, chitosan, cellulose, crosslinked starch or crosslinked cellulose. Among them, the synthetic resin fine particle is advantageous, for example, in easiness of particle size control or easiness for controlling the desired surface characteristics by surface modification.

As the organic resin fine particle, an organic resin fine particle containing a silica component is preferred, and a silica-covered fine particle which is an organic resin fine particle the surface of which is partially covered with a silica layer is particularly preferred. According to the existence of silica at least partially on the surface of the organic resin fine particle, improvement in the affinity between the organic resin fine particle and the binder (polyvinyl alcohol) is achieved, and dropout of the organic resin fine particle from the overcoat layer is restrained even when an external stress is applied to the overcoat layer, thereby maintaining excellent scratch resistance and adhesion resistance.

In case of incorporating the organic resin fine particle (silica-covered fine particle) into the overcoat layer, the amount thereof may be from 5 to 1,000 mg/$m^2$.

Then, as for the support 14 having the overcoat layer coated, the overcoat layer is dried in the overcoat layer coating and drying unit 26.

The coating of the overcoat layer can be conducted in the same manner as in the coating of the undercoat, backcoat layer or coating solution for image-recording layer and the drying thereof can also be conducted in the same manner as in the drying of the undercoat, backcoat layer or coating solution for image-recording layer after coating. The coating amount of the overcoat layer is preferably in a range from 0.01 to 10 g/$m^2$, more preferably in a range from 0. 02 to 3 g/$m^2$, most preferably in a range from 0. 02 to 1 g/$m^2$, in terms of coating amount after drying.

[Surface treatment of aluminum support]

As shown in Fig. 1, a long-length support 14 wound up in roll form is set on an unwinder 12. The support 14 continuously set out from the unwinder 12 is subjected to surface treatment in a surface treatment unit 16.

As the support 14 for use in the invention, a dimensionally stable aluminum or its alloy (for example, an alloy with silicon, copper, manganese, magnesium, chromium, zinc, lead, bismuth or nickel) is employed. Ordinarily, conventionally known materials described in Aluminum Handbook, Fourth edition (1990, published by Japan Light Metal Association), for example, JIS A 1050 material, JIS A 1100 material, JIS A 3103 material, JIS A 3004 material, JIS A 3005 material or alloys prepared by adding not less than 0. 1% by weight of magnesium into these materials for the purposes of increasing tensile strength are used. In case of the lithographic printing plate precursor of on-press development type containing a radical polymerizable compound, an aluminum alloy containing from 0.08 to 0.45% by weight of Fe and from 0. 05 to 0.20% by weight of Si and having an Al-Fe type intermetallic compound content of not more than 0.05% by weight is preferably used.

When the support 14 is an aluminum plate, it is ordinary that its surface is subjected to various treatments depending on the purposes in the surface treatment unit 16. According to an ordinary treatment method, the aluminum plate is subjected to degreasing or to an electrolytic polishing treatment and a desmut treatment to clean the surface of the aluminum plate. Subsequently, the aluminum plate is subjected to a mechanical roughening treatment or/and an electrochemical roughening treatment to form fine irregularities on the surface thereof. Further, a chemical etching treatment and a desmut treatment are additionally conducted in some cases. Subsequently, in order to increase an abrasion resistance of the surface of the aluminum plate, the aluminum plate is subjected to an anodizing treatment and then, if desired, a hydrophilizing treatment and/or a sealing treatment are conducted on the surface of the aluminum plate.

As the support for use in the lithographic printing plate precursor according to the invention, an aluminum plate subjected to roughening treatment and anodizing treatment according to a known method is preferred. Also, other treatments, for example, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4, 153, 461 and 4,689,272 may be appropriately selected and applied to the aluminum plate, if desired. The support preferably has a center line average roughness from 0.10 to 1.2 μm.

[Coating and drying of backcoat layer and undercoat layer]

Then, in a backcoat layer coating and drying unit 18, a covering layer composed of an organic polymer compound for preventing the occurrence of scratch in the photosensitive composition layer when stacked (for example, a backcoat layer containing an organic polymer compound described in JP-A-5-45885 or a backcoat layer containing an alkoxy compound of silicon described in JP-A-6-35174) is provided, if desired.

Then, in an undercoat coating and drying section 20, a coating solution for undercoat layer is coated on the surface of the support 14 and dried to from an undercoat layer, if desired. As to the system and condition of the coating in the undercoat coating and drying unit 20, most of the system and condition of the coating of the photosensitive composition layer described hereinafter can be utilized.

The undercoat layer strengthens adhesion between the support and the image-recording layer in the exposed area and makes removal of the image-recording layer from the support in the unexposed area easy, thereby contributing improvement in the development property without accompanying degradation of the printing durability. Further, it is advantageous that in the case of infrared laser exposure, since the undercoat layer acts as a heat insulating layer, decrease in sensitivity due to diffusion of heat generated upon the exposure into the support is prevented.

As a compound for use in the undercoat layer, specifically, for example, a silane coupling agent having an addition-polymerizable ethylenic double bond reactive group described in JP-A-10-282679 and a phosphorus compound having an ethylenic double bond reactive group described in JP-A-2-304441 are preferably exemplified. A polymer resin having an adsorbing group capable of adsorbing to a surface of the support, a hydrophilic group and a crosslinkable group as described in JP-A-2005-125749 and JP-A-2006-188038 is more preferably exemplified. The polymer resin is preferably a copolymer of a monomer having an adsorbing group, a monomer having a hydrophilic group and a monomer having a crosslinkable group. More specifically, a polymer resin which is a copolymer of a monomer having an adsorbing group, for example, a phenolic hydroxy group, a carboxyl group, $-PO_3H_2$, $-OPO_3H_2$, $-CONHSO_2-$ $-SO_2NHSO_2-$ and $-COCH_2COCH_3$, a monomer having a hydrophilic sulfo group and a monomer having a polymerizable crosslinkable group, for example, a methacryl group or an allyl group. The polymer resin may contain a crosslinkable group introduced by a salt formation between a polar substituent of the polymer resin and a compound containing a substituent having a counter charge to the polar substituent of the polymer resin and an ethylenically unsaturated bond and also may be further copolymerized with a monomer other than those described above, preferably a hydrophilic monomer.

The content of the unsaturated double bond in the polymer resin for undercoat layer is preferably from 0.1 to 10.0 mmol, most preferably from 2.0 to 5.5 mmol, based on 1 g of the polymer resin.

The weight average molecular weight of the polymer resin for undercoat layer is preferably 5, 000 or more, more preferably from 10, 000 to 300,000.

The undercoat layer is coated according to a known method. The coating amount (solid content) of the undercoat layer is preferably from 0.1 to 100 $mg/m^2$, and more preferably from 1 to 30 $mg/m^2$.

In the backcoat layer coating and drying unit 18 or in the undercoat coating and drying unit 20, as a method for coating the backcoat layer or the undercoat layer, for example, a method of using a coating rod, a method of using an extrusion type coater or a method of using a slide bead coater can be employed.

Also, in the backcoat layer coating and drying unit 18 or in the undercoat coating and drying unit 20, as a method for drying the backcoat layer coated or the undercoat layer coated, for example, a method for drying wherein pass rollers are placed in the drying apparatus and hot air is blown to dry while conveying the support by making it wrapping, a method for drying wherein air is supplied through nozzles from the upper and lower sides of the support to float the support, a method for drying with radiant heat from hot plates placed above and below the web, or a method for drying wherein a heat medium is introduced into the insides of rollers and heat conduction by contact between the rollers and the support is used is employed.

In any of these methods, in order to uniformly dry the web formed by coating the coating solution on the support, the control of heating is carried out by appropriately changing the flow rate, temperature and flowing manner of the hot air or heat medium depending on the kinds of support and coating solution, coating amount, kind of solvent, travelling speed and the like. Further, two or more kinds of the drying methods may be used in combination.

[Plate making method]

The lithographic printing plate precursor according to the invention is exposed imagewise and then subjected to development processing to prepare a lithographic printing plate. The development processing includes (1) a method of developing (on-press development) by supplying at least any of dampening water and ink on a printing machine and (2) a method of developing with a developer, in particular, a method of developing with a developer stocked in an automatic developing machine.

<On-Press Development>

Plate making of the lithographic printing plate precursor according to the invention is preferably performed by an on-press development method. The on-press development method includes a step in which the lithographic printing plate precursor is imagewise exposed and a printing step in which oily ink and an aqueous component are supplied to the exposed lithographic printing plate precursor without undergoing any development processing to perform printing, and it is characterized in that the unexposed area of the lithographic printing plate precursor is removed in the course of the printing step. The imagewise exposure may be performed on a printing machine after the lithographic printing plate precursor is mounted on the printing machine or may be separately performed using a platesetter or the like. In the latter case, the exposed lithographic printing plate precursor is mounted as it is on a printing machine without undergoing a development processing step. Then, the printing operation is initiated using the printing machine with supplying oily ink and an aqueous component and at an early stage of the printing the on-press development is carried out. Specifically, the image-recording layer in the unexposed area is removed and the hydrophilic surface of support is revealed therewith to form the non-image area. As the oily ink and aqueous component, printing ink and dampening water for conventional lithographic printing can be employed, respectively.
The on-press development method is described in more detail below.
As the light source used for the image exposure in the invention, a laser is preferred. The laser for use in the invention is not particularly restricted and includes, for example, a solid laser or semiconductor laser emitting an infrared ray having a wavelength of 760 to 1,200 nm.
With respect to the infrared ray laser, the output is preferably 100 mW or more, the exposure time per pixel is preferably within 20 microseconds, and the irradiation energy is preferably from 10 to 300 mJ/cm$^2$. With respect to the laser exposure, in order to shorten the exposure time, it is preferred to use a multibeam laser device.
The exposed lithographic printing plate precursor is mounted on a plate cylinder of a printing machine. In case of using a printing machine equipped with a laser exposure apparatus, the lithographic printing plate precursor is mounted on a plate cylinder of the printing machine and then subjected to the imagewise exposure.
When dampening water and printing ink are supplied to the imagewise exposed lithographic printing plate precursor to perform printing, in the exposed area of the image-recording layer, the image-recording layer cured by the exposure forms the printing ink receptive area having the oleophilic surface. On the other hand, in the unexposed area, the uncured image-recording layer is removed by dissolution or dispersion with the dampening water and/or printing ink supplied to reveal the hydrophilic surface in the area. As a result, the dampening water adheres on the revealed hydrophilic surface and the printing ink adheres to the exposed area of the image-recording layer, whereby printing is initiated.
While either the dampening water or printing ink may be supplied at first on the surface of lithographic printing plate precursor, it is preferred to supply the printing ink at first in view of preventing the dampening water from contamination with the component of the image-recording layer removed.
Thus, the lithographic printing plate precursor according to the invention is subj ected to the on- press development on an offset printing machine and used as it is for printing a large number of sheets.

<Method of developing with developer, in particular, method of developing with developer stocked in automatic developing machine>

The lithographic printing plate precursor prepared according to the invention is subjected to the development processing with a developer, particularly, a developer having pH from 2 to 11 to remove together the overcoat layer and the unexposed area of the image-recording layer so that the resulting lithographic printing plate can be immediately mounted on a printing machine to perform printing. According to a conventional developing process using an alkali developer as in (1), an overcoat layer is removed in a pre-water washing step, the alkali development is conducted, the alkali is removed by washing with water in a post-water washing step, gum solution treatment is conducted and drying is conducted in a drying step. According to the invention, it is preferred that a surfactant or a water-soluble polymer compound is incorporated into the developer and it is preferred that development and gum solution treatment are conducted at the same time. Therefore, the post-water washing step is not particularly necessary and after conducting the development and gum solution treatment with one solution, the drying step is preferably performed. Further, the pre-water washing step is also not particularly necessary and removal of the overcoat layer is also preferably conducted simultaneously with the development and gum solution treatment. It is also preferred that after the development and gum treatment, the excess developer is removed using a squeeze roller, followed by conducting drying. The development of the photosensitive lithographic printing plate precursor according to the invention is performed in a conventional manner at temperature ordinarily from 0 to 60°C, preferably from about 15 to about 40°C, using, for example, a method wherein the exposed photosensitive lithographic printing plate precursor is immersed in the developer and rubbed with a brush or a method wherein the developer is sprayed to the exposed photosensitive lithographic printing plate precursor and the exposed photosensitive lithographic printing plate precursor is rubbed with a brush.

The development processing by an automatic developing machine is advantageous in view of being free from the measures against development scum resulting from the overcoat layer and/or image-recording layer encountered in case of the on-press development as in (3).

The developer for use in the invention is an aqueous solution having pH from 2 to 11. It is preferably an aqueous solution containing water as a main component (containing 60% by weight or more of water). In particular, an aqueous solution containing a surfactant (for example, an anionic, nonionic, cationic or amphoteric surfactant) or an aqueous solution containing a water-soluble polymer compound is preferred. An aqueous solution containing both the surfactant and the water-soluble polymer compound is also preferred. The pH of the developer is more preferably from 5 to 10.7, still more preferably from 6 to 10.5, and most preferably from 7 to 10.3.

The anionic surfactant for use in the developer according to the invention is not particularly limited and includes fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di) sulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant for use in the developer according to the invention is not particularly limited, and conventionally known cationic surfactants can be used. Examples of the cationic surfactant include alkylamine salts, quaternary ammonium salts, polyoxyethylene alkyl amine salts and polyethylene polyamine derivatives.

The nonionic surfactant for use in the developer according to the invention is not particularly limited and includes polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol or sorbitan, fatty acid esters of sucrose, alkyl ethers of polyhydric alcohols and fatty acid amides of alkanolamines. Of the compounds, those having an aromatic ring and an ethylene oxide chain are preferred, and an alkyl-substituted or unsubstituted phenol ethylene oxide adduct and an alkyl-substituted or unsubstituted naphthol ethylene oxide adduct are more preferred.

The amphoteric surfactant for use in the developer according to the invention is not particularly limited and includes an amine oxide type, for example, alkyldimethylamine oxide, a betaine type, for example, alkyl betaine and an amino acid type, for example, sodium salt of alkylamino fatty acid.

In Particular, an alkyldimethylamine oxide which may have a substituent, an alkyl carboxy betaine which may have a substituent and an alkyl sulfo betaine which may have a substituent are preferably used. Specific examples of the compound used include compounds described, for example, in Paragraph Nos. [0255] to [0278] of JP-A-2008-203359 and Paragraph Nos. [0028] to [0052] of JP-A-2008-276166.

Two or more kinds of the surfactants may be used in combination. The rate of the surfactant in the developer is preferably from 0.01 to 20% by weight, and more preferably from 0.1 to 10% by weight.

The water-soluble polymer compound for use in the developer according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, known soybean polysaccharide can be used. For example, as a commercial product, SOYAFIVE (trade name, produced by Fuji Oil Co., Ltd.) is available and various grade products can be used.

The soybean polysaccharide preferably used is that having viscosity in a range from 10 to 100 mPa/sec in the 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more kinds of the water-soluble polymer compounds may be used in combination. The content of the water-soluble polymer compound in the developer is preferably from 0.1 to 20% by weight, and more preferably from 0.5 to 10% by weight.

The developer for use in the invention may further contain a pH buffer agent.

As the pH buffer agent used in the invention, a pH buffer agent exhibiting a pH buffer function at pH from 2 to 11 is used without particular restriction. In the invention, a weak alkaline buffer agent is preferably used and includes, for example, (a) a combination of a carbonate ion and a hydrogen carbonate ion, (b) a borate ion, (c) a water-soluble amine compound and an ion of the water-soluble amine compound, and combinations thereof. Specifically, for example, (a) a combination of a carbonate ion and a hydrogen carbonate ion, (b) a borate ion, or (c) a combination of a water-soluble organic amine compound and an ion of the water-soluble amine compound exhibits a pH buffer function in the developer to prevent fluctuation of the pH even when the developer is used for a long period of time. As a result, for example, the deterioration of development property resulting from the fluctuation of pH and the occurrence of development scum are restrained. The combination of a carbonate ion and a hydrogen carbonate ion is particularly preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferred. The alkali metals may be used individually or in combination of two or more thereof.

When the combination (a) of a carbonate ion and a hydrogen carbonate ion is adopted as the pH buffer agent, the total amount of the carbonate ion and hydrogen carbonate ion is preferably from 0.05 to 5 mole/l, more preferably from 0.1 to 2 mole/l, particularly preferably from 0.2 to 1 mole/l, based on the total weight of the aqueous solution.

The developer according to the invention may contain an organic solvent. As the organic solvent to be contained, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or monochlorobenzene) or a polar solvent is exemplified.

Examples of the polar solvent include an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine, N-phenyldiethanolamine).

Further, when the organic solvent is insoluble in water, it may be employed by being solubilized in water using a surfactant or the like. In the case where the developer contains an organic solvent, the concentration of the organic solvent is desirably less than 40% by weight in view of safety and inflammability.

The developer according to the invention may contain a preservative, a chelating agent, a defoaming agent, an organic acid, an inorganic acid, an inorganic salt or the like in addition the components described above. Specifically, compounds described in Paragraph Nos. [0266] to [0270] of JP-A-2007-206217 are preferably used.

The developer described above can be used as a developer and a development replenisher for the exposed negative lithographic printing plate precursor and it is preferably applied to an automatic processor described hereinafter. In the case of conducting the development processing using an automatic processor, the developer becomes fatigued in accordance with the processing amount, and hence the processing ability may be restored using a replenisher or a fresh developer.

The development processing using the aqueous solution having pH from 2 to 11 according to the invention is preferably performed by an automatic processor equipped with a supplying means for the developer and a rubbing member. An automatic processor using a rotating brush roll as the rubbing member is particularly preferred.

Further, the automatic processor is preferably provided with a means for removing the excess developer, for example, a squeeze roller or a drying means, for example, a hot air apparatus, subsequently to the development processing means.

In addition, in the plate making process of preparing a lithographic printing plate from the lithographic printing plate precursor according to the invention, the lithographic printing plate precursor may be heated its entire surface before or during the exposure or between the exposure and the development, if desired. By the heating, the image-forming reaction in the image-recording layer is accelerated and advantages, for example, improvement in the sensitivity and printing durability and stabilization of the sensitivity are achieved. For the purpose of increasing the image strength and printing durability, it is also effective to perform entire after-heating or entire exposure of the image after the development. Ordinarily, the heating before the development is preferably performed under a mild condition of 150°C or lower. When the temperature is too high, a problem may arise sometimes in that the unexposed area is also cured. On the other hand, the heating after the development can be performed using very strong conditions. Ordinarily, the heat treatment is carried out in a temperature range from 100 to 500°C. When the temperature is too low, a sufficient effect of strengthening the image may not be obtained, whereas when it is excessively high, problems of deterioration of the support and thermal decomposition of the image area may occur sometimes.

In advance of the above-described development processing, the lithographic printing plate precursor is imagewise exposed with laser through a transparent original having a line image, a halftone dot image or the like, or imagewise exposed, for example, by scanning of laser beam based on digital data.

The wavelength of the exposure light source is preferably from 300 to 450 nm or from 750 to 1,400 nm. In case of exposing with light of 300 to 450 nm, the lithographic printing plate precursor having an image-recording layer containing a sensitizing dye having an absorption maximum in such a wavelength range is used. In case of exposing with light of 750 to 1, 400 nm, the lithographic printing plate precursor containing an infrared absorbing agent which is a sensitizing dye having an absorption maximum in such a wavelength range is used. As the light source of 300 to 450 nm, a semiconductor laser is preferably used. As the light source of 750 to 1,400 nm, a solid laser or semiconductor laser emitting an infrared ray is preferably used. The exposure mechanism may be any of an internal drum system, an external drum system and a flat bed system.

EXAMPLE

The present invention will be described in detail with reference to the following examples, but the invention should not be construed as being limited thereto. In the examples, a dying test of the image-recording layer is performed utilizing the production line 10 shown in Fig. 1 and the drying apparatus 40 shown in Fig. 2. A molecular weight of the polymer compound used means a weight average molecular weight and a ratio of repeating unit is indicated in molar ratio.

Examples 1 to 12 and Comparative Examples 1 to 2

[Preparation of Lithographic printing plate precursors]

(1) Preparation of Support (No. 1)

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0. 3 mm and an aqueous suspension (specific gravity: 1.1 g/cm$^3$) of pumice having a median size of 25 μm, followed by thorough washing with water. The plate was subjected to etching by immersing in a 25% by weight aqueous sodium hydroxide solution of 45°C for 9 seconds, washed with water, then immersed in a 20% by weight nitric acid solution at 60°C for 20 seconds, and washed with water. The etching amount of the grained surface was about 3 g/m$^2$.

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using an alternating current source, which provides a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm$^2$ in terms of the peak value of the electric current, and 5% of the electric current flowing from the electric source was divided to the auxiliary anode. The quantity of electricity in the nitric acid electrolysis was 175 C/dm$^2$ in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/dm$^2$ in terms of the quantity of electricity when the aluminum plate functioned as an anode. The plate was then

washed with water by spraying.
The plate was then subjected to an anodizing treatment using as an electrolytic solution, a 15% by weight sulfuric acid solution (containing 0.5% by weight of aluminum ion) at a current density of 15 A/dm$^2$ to form a direct current anodized film of 2.5 g/m$^2$, washed with water and dried to prepare Support (1).
Thereafter, in order to ensure the hydrophilicity of the non-image area, Support (1) was subjected to silicate treatment using a 2.5% by weight aqueous sodium silicate No. 3 solution at 60°C for 10 seconds and then was washed with water to obtain Support (2). The adhesion amount of Si was 10 mg/m$^2$. The center line average roughness (Ra) of the support was measured using a stylus having a diameter of 2 μm and found to be 0.51 μm.

(2) Formation of Undercoat layer

Coating solution (1) for undercoat layer shown below was coated on Support (2) described above so as to have a dry coating amount of 20 mg/m$^2$ and then dried at 80°C for 10 seconds using a hot air drying apparatus to prepare a support having an undercoat layer for using in the experiments described below.

<Coating solution (1) for undercoat layer>

| | |
|---|---|
| Compound (1) for undercoat layer having structure shown below | 0.18 g |
| Hydroxyethyliminodiacetic acid | 0.10 g |
| Methanol | 55.24 g |
| Water | 6.15 g |

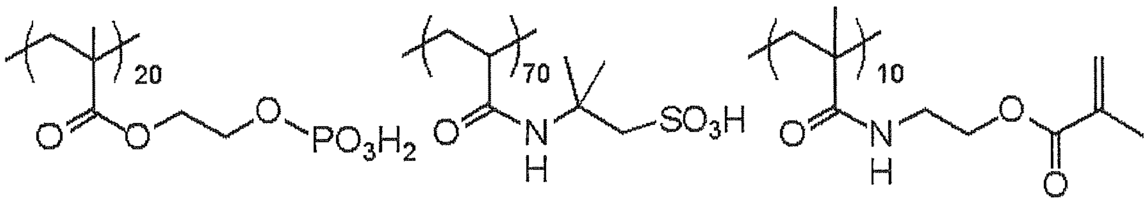

(Mw: 100,000)

Compound (1) for undercoat layer

(3) Formation of Image-recording layer (1)

Coating solution (1) for image-recording layer having the composition shown below was coated on the undercoat layer described above using a bar coater. The image-recording layer coated was dried under conditions described in Table 1 to confirm the performances. The dry coating amount of the image-recording layer was 1.0 g/m$^2$.
Coating solution (1) for image-recording layer was prepared by mixing Photosensitive solution (1) shown below with Microgel solution (1) shown below just before the coating, followed by stirring.

<Photosensitive solution (1)>

| | |
|---|---|
| Binder polymer (1) having structure shown below | 0.240 g |
| Infrared absorbing dye (1) having structure shown below | 0.030 g |
| Radical polymerization initiator (1) having structure shown below | 0.162 g |
| Radical polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |

(continued)

| | |
|---|---|
| Hydrophilic low molecular weight compound (1) having structure shown below | 0.050 g |
| Ammonium group-containing polymer having structure shown below (reduced specific viscosity: 44 cSt/g/ml) | 0.035 g |
| Fluorine-based surfactant (1) having structure shown below | 0.008 g |
| 2-Butanone | 1.091 g |
| 1-Methoxy-2-propanol | 8.609 g |

<Microgel solution (1)>

| | |
|---|---|
| Microgel (1) | 2.640 g |
| Distilled water | 2.425 g |

The structures of Binder polymer (1), Radical polymerization initiator (1), Infrared absorbing dye (1), Hydrophilic low molecular weight compound (1), Fluorine-based surfactant (1) and Ammonium group-containing polymer and the preparation method of Microgel (1) are shown below.

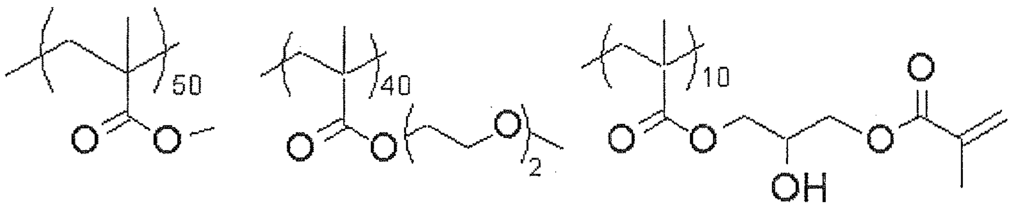

(Mw: 70,000)

Binder polymer (1)

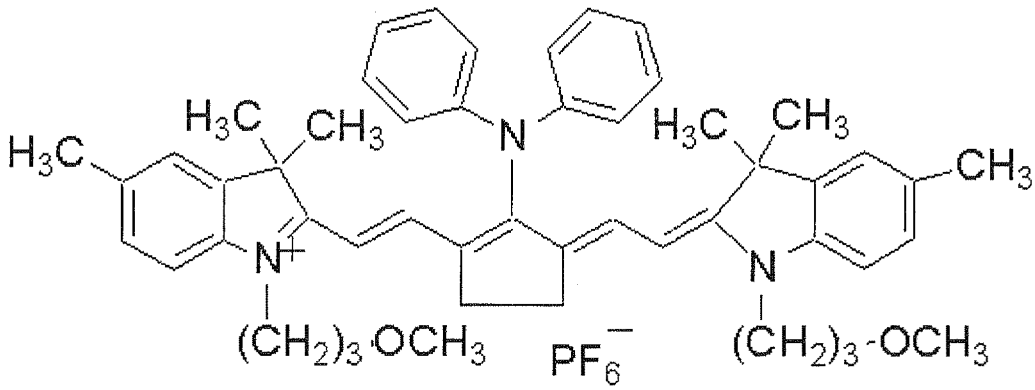

Infrared absorbing dye (1)

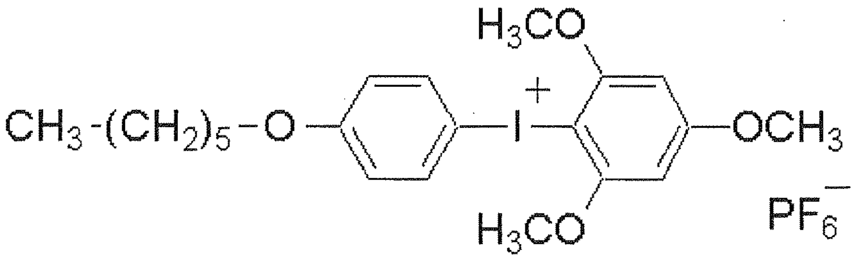

Radical polymerization initiator (1)

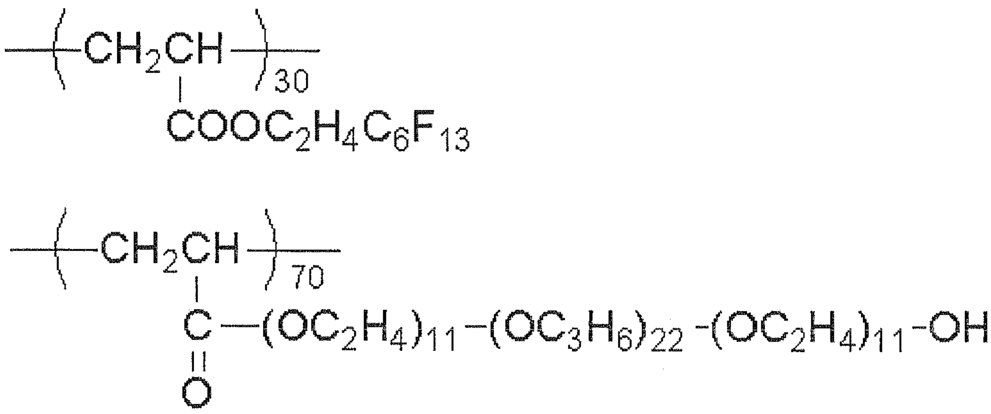

(Mw: 13,000)

Fluorine-based surfactant (1)

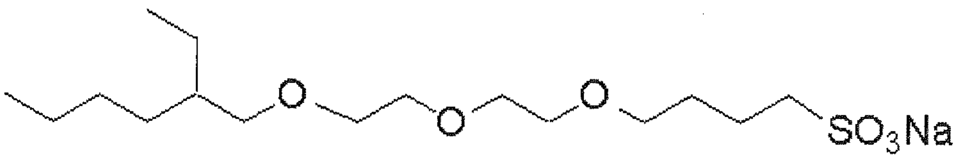

Hydrophilic low molecular weight compound (1)

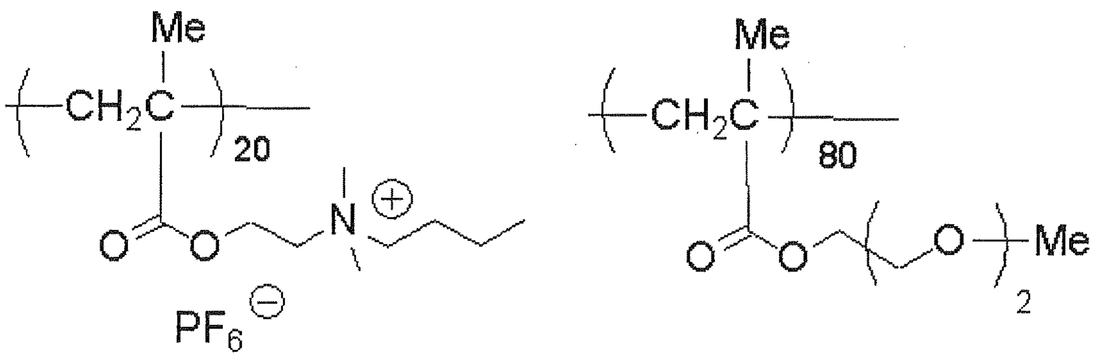

Ammonium group-containing polymer

<Preparation of Microgel (1)>

An oil phase component was prepared by dissolving 10 g of adduct of trimethylol propane and xylene diisocyanate (TAKENATE D-110N, produced by Mitsui Chemicals Polyurethanes, Inc.), 3.15 g of pentaerythritol triacrylate (SR444, produced by Nippon Kayaku Co., Ltd.) and 0.1 g of PIONIN A-41C (produced by Takemoto Oil & Fat Co., Ltd.)

in 17 g of ethyl acetate. As an aqueous phase component, 40 g of a 4% by weight aqueous solution of PVA-205 was prepared. The oil phase component and the aqueous phase component were mixed and emulsified using a homogenizer at 12,000 rpm for 10 minutes. The resulting emulsion was added to 25 g of distilled water and stirred at room temperature for 30 minutes and then at 50°C for 3 hours. The microgel liquid thus-obtained was diluted using distilled water so as to have the solid content concentration of 15% by weight to prepare Microgel (1). The average particle size of the microgel was measured by a light scattering method and found to be 0.2 μm.

(4) Formation of Overcoat layer

Coating solution (1) for overcoat layer having the composition shown below was coated on the image-recording layer described above by a bar coater and dried with hot air at 150°C for 20 seconds to form an overcoat layer having a dry coating amount of 0.15 g/$m^2$, thereby preparing lithographic printing plate precursors for Examples 1 to 12 and lithographic printing plate precursors for Comparative Examples 1 and 2, respectively.

<Coating solution (1) for overcoat layer>

| | |
|---|---|
| Dispersion of inorganic stratiform compound (1) | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.03 g |
| Aqueous 1% by weight solution of surfactant (EMALEX 710, produced by Nihon Emulsion Co., Ltd.) | 0.86 g |
| Ion-exchanged water | 6.0 g |

(Preparation of Dispersion of inorganic stratiform compound (1))

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 μm. The aspect ratio of the inorganic particle thus-dispersed was 100 or more. The lithographic printing plate precursors for comparative examples (Comparative Examples 1 and 2) were prepared in the same manner as in Example 1 except that the image-recording layer was dried only by conducting ordinary hot air drying without conducting superheated vapor treatment.

[Evaluation of Lithographic printing plate precursor]

(1) Mixed amount of overcoat layer

The lithographic printing plate precursor thus-obtained was overall exposed by LUXEL PLATESETTER T-6000III equipped with an infrared semiconductor laser (produced by FUJIFILM Corp.) under the conditions of a rotational number of an external drum of 1,000 rpm, laser output of 70% and resolution of 2,400 dpi. The exposed lithographic printing plate precursor was washed to remove the overcoat layer on the image-recording layer and a mixed amount of the overcoat layer in the imager-recording layer was determined. Specifically, the exposed lithographic printing plate precursor was immersed in water of 25°C for 30 seconds and then the surface of lithographic printing plate precursor was rubbed ten times using a cellulose sponge. Based on a weight of the lithographic printing plate precursor after drying (A) and a weight of the lithographic printing plate precursor before washing with water (B), the mixed amount of overcoat layer (%) was calculated according to a calculation formula shown below.

Mixed amount of overcoat layer (%) = ((B) - (A))/Coating amount of overcoat layer x 100

Also, in the case where the overcoat layer contains mica, the mixed amount of overcoat layer can be estimated by measuring intensity of magnesium (derived from mica) before and after the washing with water and comparing them

with each other.

(2) On-press development property

The lithographic printing plate precursor thus-obtained was lapped with an aluminum kraft paper together with an interleaf and a backing cardboard each moisture-controlled at 25°C and 70% RH and stored for 4 days in an oven at 60°C.
The lithographic printing plate precursor thus-accelerated by heating was exposed by LUXEL PLATESETTER T-6000III equipped with an infrared semiconductor laser (produced by FUJIFILM Corp.) under the conditions of a rotational number of an external drum of 1,000 rpm, laser output of 70% and resolution of 2,400 dpi. The exposed image contained a solid image and a 50% halftone dot chart of a 20 μm-dot FM screen.
The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (volume ratio)) and VALUES-G (N) Black Ink (produced by Dainippon Ink & Chemicals, Inc.), the dampening water and ink were supplied according to the standard automatic printing start method of LITHRONE 26 to conduct printing on 100 sheets of TOKUBISHI art paper (76.5 kg) at a printing speed of 10,000 sheets per hour.
A number of the printing papers required until the removal of the unexposed area of the image-recording layer on the printing machine was completed to reach a state where the ink was not transferred to the printing paper in the non-image area was measured to evaluate the on-press development property. The results obtained are shown in Table 1.

(3) Printing durability

The lithographic printing plate precursor thus-obtained was exposed by LUXEL PLATESETTER T-6000III equipped with an infrared semiconductor laser (produced by FUJIFILM Corp.) under the conditions of a rotational number of an external drum of 1,000 rpm, laser output of 70% and resolution of 2, 400 dpi. The exposed image contained a solid image and a 50% halftone dot chart of a 20 μm-dot FM screen.
The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (volume ratio)) and VALUES-G (N) Black Ink (produced by Dainippon Ink & Chemicals, Inc.), the dampening water and ink were supplied according to the standard automatic printing start method of LITHRONE 26 to conduct printing on TOKUBISHI art paper (76.5 kg) at a printing speed of 10,000 sheets per hour.
As the increase in a number of printing papers, the image-recording layer was gradually abraded to cause decrease in the ink density on the printed material. A number of printing papers wherein a value obtained by measuring a halftone dot area rate of the 50% halftone dot of FM screen on the printed material using a Gretag densitometer decreased by 5% from the value measured on the 100th paper of the printing was determined to evaluate the printing durability. The results obtained are shown in Table 1.
TABLE 1

| | Hot Air Drying Condition (Note 3) | | | Superheated Vapor Supplying Condition (Note 4) | | | | Performance (Note 2) | | |
|---|---|---|---|---|---|---|---|---|---|---|
| | Temperature | Air Volume | Time | Surface Temperature (Note 1) | Temperature | Water Vapor Amount | Time | Mixed Amount of Overcoat Layer | On-press Development Property | Printing Durability |
| | (°C) | (m/sec) | (seconds) | (°C) | (°C) | ($g/m^3$) | (seconds) | (%) | (sheets) | (x $10^4$ sheets) |
| Example 1 | 140 | 6 | 40 | 110 | 150 | 400 | 1 | 35 | 35 | 4.2 |
| Example 2 | 140 | 6 | 40 | 110 | 150 | 400 | 5 | 29 | 25 | 4.3 |
| Example 3 | 140 | 6 | 40 | 110 | 150 | 400 | 10 | 21 | 20 | 4.5 |
| Example 4 | 140 | 6 | 40 | 110 | 150 | 400 | 15 | 17 | 30 | 4.6 |
| Example 5 | 140 | 6 | 40 | 110 | 150 | 100 | 5 | 37 | 30 | 4.1 |
| Example 6 | 140 | 6 | 40 | 110 | 150 | 300 | 5 | 31 | 25 | 4.2 |
| Example 7 | 140 | 6 | 40 | 110 | 150 | 300 | 10 | 25 | 17 | 4.3 |
| Example 8 | 140 | 6 | 40 | 110 | 150 | 480 | 5 | 21 | 28 | 4.7 |
| Example 9 | 140 | 6 | 40 | 110 | 150 | 400 | 0.2 | 44 | 45 | 4.0 |
| Example 10 | 140 | 6 | 40 | 110 | 150 | 400 | 17 | 14 | 40 | 4.7 |
| Example 11 | 140 | 6 | 40 | 110 | 150 | 30 | 5 | 45 | 50 | 4.0 |
| Example 12 | 140 | 6 | 40 | 110 | 150 | 550 | 5 | 20 | 40 | 4.2 |
| Comparative Example 1 | 140 | 6 | 40 | - | - | - | - | 50 | 100 | 3.3 |
| Comparative Example 2 | 180 | 6 | 40 | - | - | - | - | 43 | 200 | 3.7 |

(Note 1) : Surface temperature of the image-recording layer at an inlet of the second drying unit 24b shown in Fig. 2.
(Note 2) : The on-press development property of 50 sheets or less and the printing durability of 4.0 x $10^4$ sheets or more are regarded as acceptable levels, respectively.
(Note 3) : The hot air drying condition means the conditions of hot air blown from the nozzle 46 shown in Fig. 2. The dew point of the hot air was 8°C.
(Note 4): The superheated vapor supplying condition means the conditions of hot air containing superheated vapor blown from the nozzle 50 shown in Fig. 2.

Examples 21 to 34 and Comparative Examples 11 and 12

[Preparation of Lithographic printing plate precursor]

(1) Formation of Image-recording layer

Coating solution (2) for image-recording layer shown below was coated on the support having the undercoat layer described above using a bar coater. The image-recording layer coated was dried under conditions described in Table 2 to confirm the performances. The dry coating amount of the image-recording layer was 1.1 g/$m^2$.

<Coating solution (2) for image-recording layer>

| | |
|---|---|
| Aqueous dispersion (1) of polymer fine particle | 4.0 g |
| Infrared absorbing dye (2) having structure shown below | 0.2g |
| Radical polymerization initiator (IRGACURE 250, produced by Ciba Specialty Chemicals, Inc.) | 0.5 g |
| Radical polymerizable compound (SR-399, produced by Sartomer Co.) | 1.50 g |
| Mercapto-3-triazole | 0.2 g |
| BYK 336 (produced by BYK-Chimie GmbH) | 0.4 g |
| KLUCEL M (produced by Hercules Chemical Co., Inc.) | 4.8 g |
| ELVACITE 4026 (produced by Ineos Acrylica Inc.) | 2.5 g |
| n-Propanol | 55.0 g |
| 2-Butanone | 17.0 g |

The compounds indicated using their trade names in the composition above are shown below.
IRGACURE 250: (4-Methoxyphenyl)[4-(2-methylpropyl)phenyl]iodonium hexafluorophosphate (75% by weight propylene carbonate solution) SR-399: Dipentaerythritol pentaacrylate
BYK 336: Modified dimethylpolysiloxane copolymer (25% by weight xylene/methoxypropyl acetate solution)
KLUCEL M: Hydroxypropyl cellulose (2% by weight aqueous solution) ELVACITE 4026: Highly branched polymethyl methacrylate (10% by weight 2-butanone solution)

[ka 9]

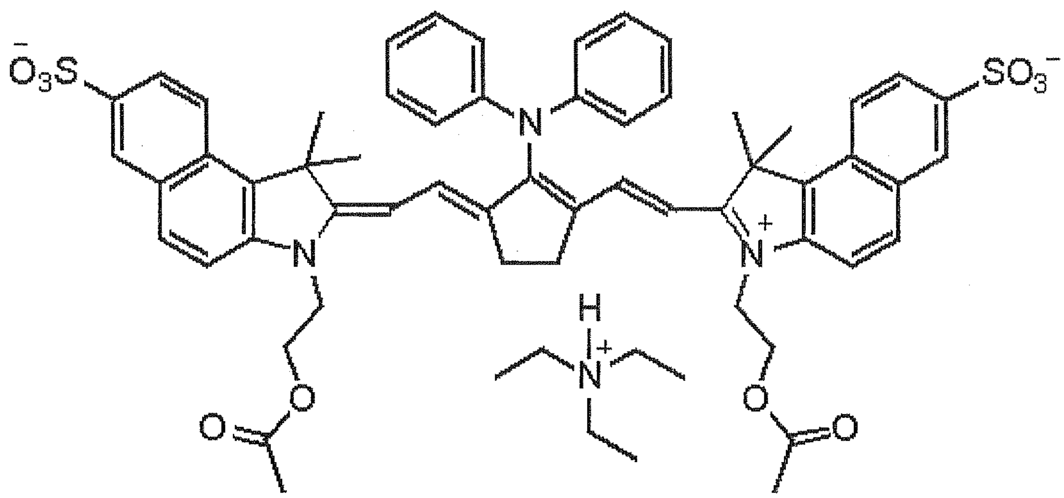

Infrared absorbing dye (2)

(Preparation of Aqueous dispersion (1) of polymer fine particle)

A stirrer, a thermometer, a dropping funnel, a nitrogen inlet tube and a reflux condenser were attached to a 1, 000 ml four-neck flask and while carrying out deoxygenation by introduction of nitrogen gas, 10 g of polyethylene glycol methyl ether methacrylate (PEGMA, average repeating unit number of ethylene glycol: 50), 200 g of distilled water and 200 g of n-propanol were charged therein and heated until the internal temperature reached 70°C. Then, a mixture of 10 g of styrene (St), 80 g of acrylonitrile (AN) and 0.8 g of 2,2' -azobisisobutyronitrile previously prepared was dropwise added to the flask over a period of one hour. After the completion of the dropwise addition, the mixture was continued to react as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion (1) of polymer fine particle of PEGMA/St/AN (10/10/80 in a weight ratio). The particle size distribution of the polymer fine particle had the maximum value at the particle size of 150 nm.

The particle size distribution was determined by taking an electron microphotograph of the polymer fine particle, measuring particle sizes of 5, 000 fine particles in total on the photograph, and dividing a range from the largest value of the particle size measured to 0 on a logarithmic scale into 50 parts to obtain occurrence frequency of each particle size by plotting. With respect to the aspherical particle, a particle size of a spherical particle having a particle area equivalent to the particle area of the aspherical particle on the photograph was defined as the particle size.

(2) Formation of Overcoat layer

Coating solution (2) for overcoat layer was further coated on the image-recording layer described above by a bar coater and dried with hot air at 150°C for 20 seconds to form an overcoat layer having a dry coating amount of 0.15 $g/m^2$, thereby preparing a lithographic printing plate precursor.

<Coating solution (2) for overcoat layer>

| | |
|---|---|
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 2.72 g |
| Aqueous 1% by weight solution of surfactant (EMALEX 710, produced by Nihon Emulsion Co., Ltd.) | 0.86 g |
| Ion-exchanged water | 2.13 g |

[Evaluation of Lithographic printing plate precursor]

The lithographic printing plate precursors thus-prepared (for Examples 21 to 34 and Comparative Examples 11 and 12) were evaluated in the same manner as in Examples 1 to 12. The results obtained are shown in Table 2.

TABLE 2

| | Hot Air Drying Condition | | | Superheated Vapor Supplying Condition | | | | Performance (Note) | | |
|---|---|---|---|---|---|---|---|---|---|---|
| | Temperature | Air Volume | Time | Surface Temperature (Note 1) | Temperature | Water Vapor Amount | Time | Mixed Amount of Overcoat Layer | On-press Development Property | Printing Durability |
| | (°C) | (m/sec) | (seconds) | (°C) | (°C) | ($g/m^3$) | (seconds) | (%) | (sheets) | (x $10^4$ sheets) |
| Example 21 | 140 | 6 | 40 | 110 | 150 | 400 | 1 | 14 | 40 | 3.7 |
| Example 22 | 140 | 6 | 40 | 110 | 150 | 400 | 5 | 14 | 25 | 3.7 |
| Example 23 | 140 | 6 | 40 | 110 | 150 | 400 | 10 | 12 | 30 | 3.8 |
| Example 24 | 140 | 6 | 40 | 110 | 150 | 400 | 15 | 9 | 35 | 4.0 |
| Example 25 | 140 | 6 | 40 | 110 | 150 | 100 | 5 | 15 | 35 | 3.5 |
| Example 26 | 140 | 6 | 40 | 110 | 150 | 300 | 5 | 14 | 27 | 3.7 |
| Example 27 | 140 | 6 | 40 | 110 | 150 | 300 | 2 | 15 | 23 | 3.6 |
| Example 28 | 140 | 6 | 40 | 110 | 150 | 480 | 5 | 9 | 29 | 4.0 |
| Example 29 | 140 | 6 | 40 | 110 | 150 | 400 | 0.1 | 19 | 45 | 3.0 |
| Example 30 | 140 | 6 | 40 | 110 | 150 | 400 | 17 | 7 | 42 | 4.2 |
| Example 31 | 140 | 6 | 40 | 110 | 150 | 30 | 5 | 19 | 50 | 3.0 |
| Example 32 | 140 | 6 | 40 | 110 | 150 | 520 | 5 | 7 | 43 | 4.2 |
| Example 33 | 140 | 6 | 40 | 110 | 150 | 400 | 0.25 | 16 | 40 | 3.6 |
| Example 34 | 140 | 6 | 40 | 110 | 150 | 50 | 5 | 17 | 37 | 3.5 |
| Comparative Example 11 | 140 | 6 | 40 | - | - | - | - | 21 | 120 | 2.7 |
| Comparative Example 12 | 180 | 6 | 40 | - | - | - | - | 15 | 210 | 3.3 |

(Note) : The on-press development property of 50 sheets or less and the printing durability of 3.0 x $10^4$ sheets or more are regarded as acceptable levels, respectively.

Examples 41 to 46 and Comparative Examples 21 and 22

[Preparation of Lithographic printing plate precursor]

(1) Preparation of Support 1 (No. 2)

An aluminum plate (material: 1050, refining: H16) having a thickness of 0.24 mm was immersed in an aqueous 5% by weight sodium hydroxide solution maintained at 65°C to conduct a degreasing treatment for one minute, followed by washed with water. The degreased aluminum plate was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 A/dm$^2$ in an aqueous 0.3% by weight hydrochloric acid solution at 25°C for 60 seconds and then subjected to a desmut treatment in an aqueous 5% by weight sodium hydroxide solution maintained at 60°C for 10 seconds. The surface-roughened and desmuted aluminum plate was subjected to an anodizing treatment under condition of current density of 10 A/dm$^2$ and voltage of 15 V in an aqueous 15% by weight sulfuric acid solution at 25°C for one minute and then subjected to a hydrophilizing treatment using an aqueous 1% by weight polyvinyl phosphonic acid solution at 75°C to prepare a support. The surface roughness of the support was measured and found to be 0.44 μm (Ra indication according to JIS B 0601).

(2) Formation of Image-recording layer

Coating solution (3) for image-recording layer shown below was coated on the support described above using a bar coater. The image-recording layer coated was dried under conditions described in Table 3 to confirm the performances. The image-recording layer having a dry coating amount of 1.3 g/m$^2$ was formed.

<Coating solution (3) for image-recording layer>

| | |
|---|---|
| Binder polymer (2) shown below (Mw: 50,000) | 0.04 g |
| Binder polymer (3) shown below (Mw: 80,000) | 0.30 g |
| Polymerizable compound (1) shown below<br>PLEX 6661-O, produced by Degussa Japan Co., Ltd.) | 0.17 g |
| Polymerizable compound (2) shown below | 0.51 g |
| Sensitizing dye (1) shown below | 0.03 g |
| Sensitizing dye (2) shown below | 0.015 g |
| Sensitizing dye (3) shown below | 0.015 g |
| Radical polymerization initiator (2) shown below | 0.13 g |
| Chain transfer agent<br>Mercaptobenzothiazole | 0.01 g |
| Dispersion of ε-phthalocyanine pigment (pigment: 15 parts by weight; dispersing agent (allylmethacrylate/methacrylic acid copolymer (Mw: 60,000, copolymerization molar ratio: 83/17)): 10 parts by weight; cyclohexanone: 15 parts by weight) | 0.40 g |
| Thermal polymerization inhibitor<br>N-Nitrosophenylhydroxylamine aluminum salt | 0.01 g |
| Water-soluble fluorine-based surfactant (2) shown below (Mw: 10,000) | 0.001 g |
| 1-Methoxy-2-propanol | 3.5 g |
| Methyl ethyl ketone | 8.0 g |

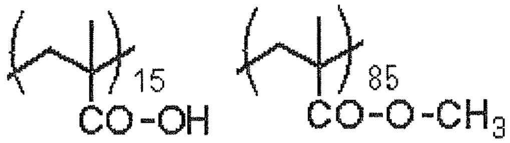

Binder polymer (2) (acid value: 85 mg KOH/g)

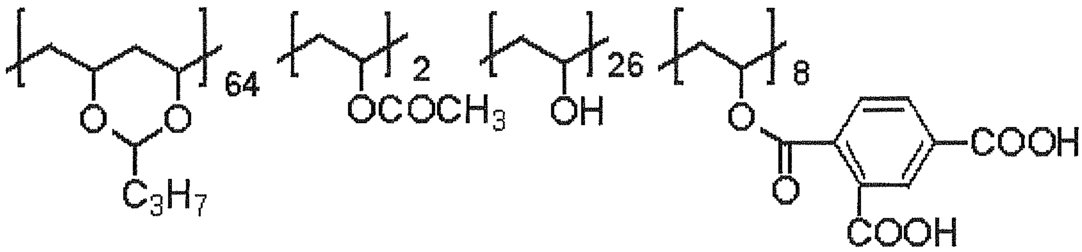

Binder polymer (3) (acid value: 66 mg KOH/g)

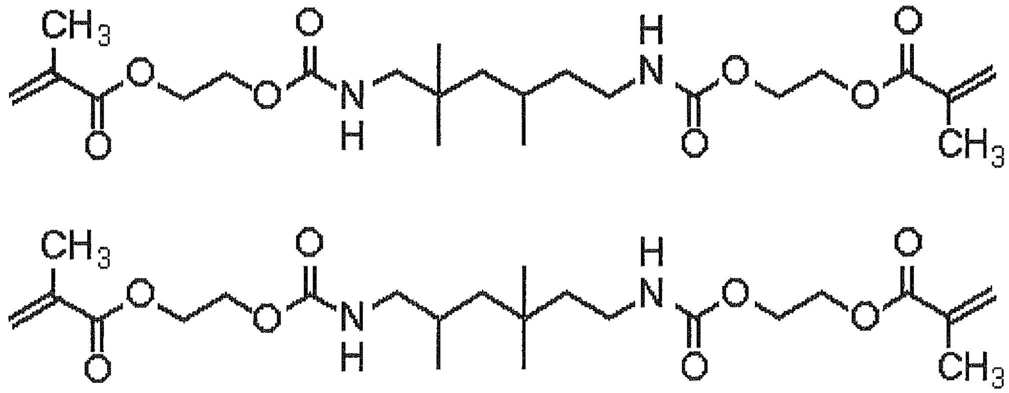

(Mixture of isomers described above)

Polymerizable compound (1)

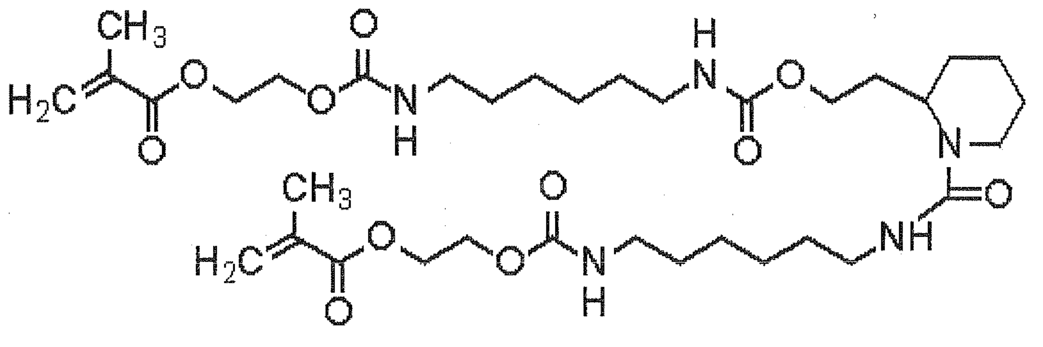

Polymerizable compound (2)

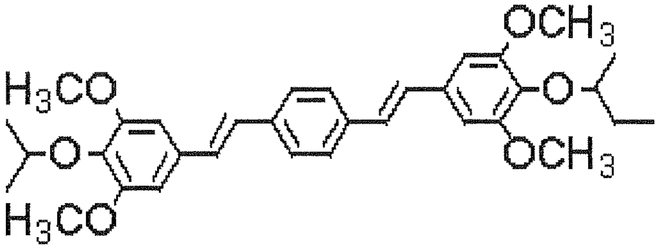

Sensitizing dye (1)

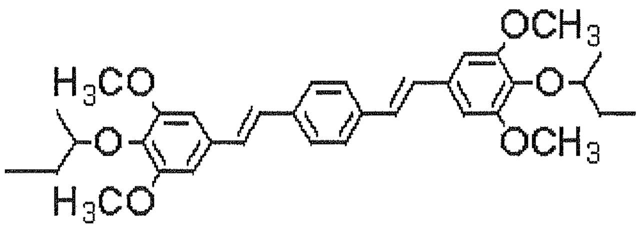

Sensitizing dye (2)

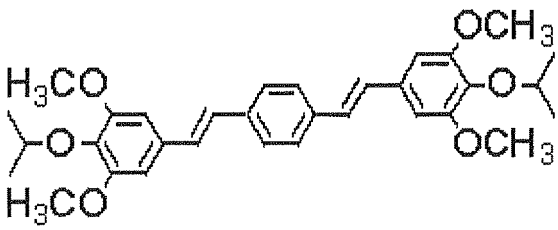

Sensitizing dye (3)

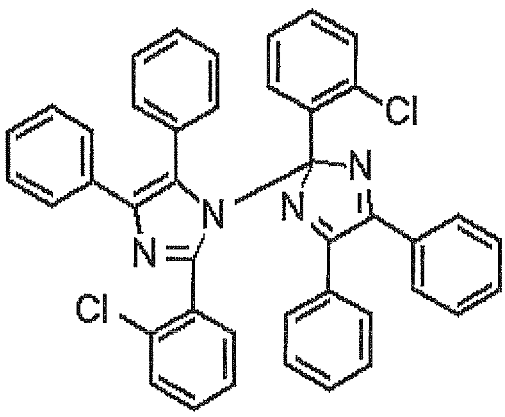

Radical polymerization initiator (2)

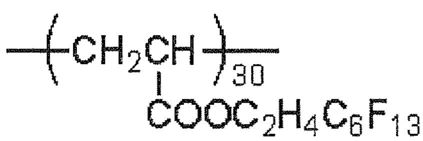

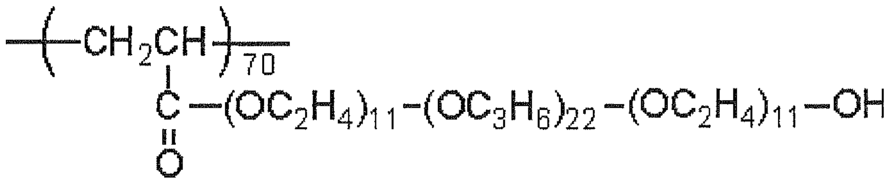

Fluorine-based surfactant (2) (Mw: 10,000)

<Formation of Overcoat layer>

Coating solution (3) for overcoat layer having the composition shown below was coated on the image-recording layer described above using a bar so as to have a dry coating amount of 1.2 g/m$^2$ and dried at 125°C for 70 seconds to form an overcoat layer, thereby preparing a lithographic printing plate precursor.

<Coating solution (3) for overcoat layer>

| | |
|---|---|
| PVA-205 (partially hydrolyzed polyvinyl alcohol, produced by Kuraray Co., Ltd. (saponification degree: 86.5 to 89.5% by mole; viscosity: 4.6 to 5.4 mPa·s in a 4% by weight aqueous solution at 20°C)) | 0.658 g |
| PVA-105 (fully hydrolyzed polyvinyl alcohol, produced by Kuraray Co., Ltd. (saponification degree: 98.0 to 99.0% by mole; viscosity: 5.2 to 6.0 mPa·s in a 4% by weight aqueous solution at 20°C)] | 0.142 g |
| Vinyl pyrrolidone/vinyl acetate (1/1) copolymer (Mw: 70,000) | 0.001 g |
| Surfactant (EMALEX 710, produced by Nihon Emulsion Co., Ltd.) | 0.002 g |
| Water | 13 g |

[Evaluation of Lithographic printing plate precursor]

(1) Exposure, Development and Printing

The lithographic printing plate precursor described above was subjected to image exposure by Violet semiconductor laser plate setter Vx9600 (equipped with InGaN semiconductor laser; emission: 405 nm ± 10 nm/output: 30 mW) produced by FUJIFILM Electronic Imaging, Ltd. The image drawing was conducted at a resolution of 2,438 dpi with halftone dots of 50% using an FM screen (TAFFETA 20, produced by FUJIFILM Corp.) under condition of a plate surface exposure amount of 0.05 mJ/cm$^2$.
Then, the exposed lithographic printing plate precursor was subj ected to development processing by an automatic developing machine (FCF-85V, produced by FUJIFILM Corp.) using Developer (1) having the composition shown below at a transporting speed so as to regulate preheating time at 100°C of 10 seconds and immersion time (developing time) in the developer of 20 seconds.
Then, the lithographic printing plate thus-obtained was mounted on a printing machine (SOR-M, produced by Heidelberg) and printing was conducted at a printing speed of 6, 000 sheets per hour using dampening water (EU-3 (etching solution, produced by FUJIFILM Corp.))/water/isopropyl alcohol = 1/89/10 (by volume ratio)) and TRANS-G (N) Black Ink (produced by Dainippon Ink & Chemicals, Inc.).

<Developer (1)>

| | |
|---|---|
| Water | 88.6 g |
| Nonionic surfactant (W-1) | 2.4 g |
| Nonionic surfactant (W-2) | 2.4 g |
| Nonionic surfactant (EMALEX 710, produced by Nihon Emulsion Co., Ltd.) | 1.0 g |
| Phenoxypropanol | 1.0 g |
| Octanol | 0.6 g |

(continued)

| | |
|---|---|
| N-(2-Hydroxyethyl)morpholine | 1.0 g |
| Triethanolamine | 0.5 g |
| Sodium gluconate | 1.0 g |
| Trisodium citrate | 0.5 g |
| Tetrasodium ethylenediaminetetraacetate | 0.05 g |
| Polystyrenesulfonic acid (VERSA TL77 (30% by weight solution) produced by Alco Chemical Inc.) | 1.0 g |

*pH was adjusted to 7.0 by adding phosphoric acid to the composition described above.

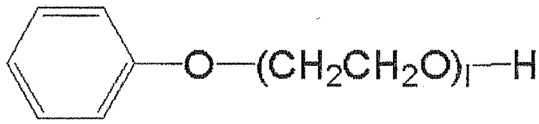

l=13-28

(W-1)

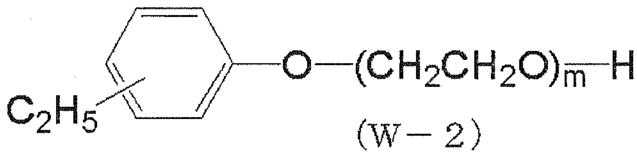

m=12-26

(W-2)

(2) Evaluation

<Development property>

The lithographic printing plate precursor was subjected to the exposure and development processing as described above. After the development processing, the non-image area of the lithographic printing plate was visually observed to evaluate the residue of the image-recording layer. The evaluation was performed according to the criteria described below.

O: No residue of the image-recording layer and good development property.
Δ: Slight residue of the image-recording layer but no problem in the development property.
X: The image-recording layer was remained and development defect.

<printing durability>

As increase in the number of printed materials, the image of the image-recording layer formed on the lithographic printing plate was gradually abraded to cause decrease in the ink receptivity, resulting in decrease in ink density of the image on a printing paper. A number of printed materials obtained until the ink density (reflection density) decreased by 0.1 from that at the initiation of printing was determined to evaluate the printing durability.

<Mixed amount of overcoat layer>

The mixed amount of overcoat layer was evaluated in the same manner as in Examples 1 to 12.

TABLE 3

| | Hot Air Drying Condition | | | Superheated Vapor Supplying Condition | | | | Performance | | |
|---|---|---|---|---|---|---|---|---|---|---|
| | Temperature | Air Volume | Time | Surface Temperature (Note 1) | Temperature | Water Vapor Amount | Time | Mixed Amount of Overcoat Layer | Development Property | Printing Durability |
| | (°C) | (m/sec) | (seconds) | (°C) | (°C) | ($g/m^3$) | (seconds) | (%) | | ($x\ 10^4$ sheets) |
| Example 41 | 140 | 6 | 40 | 110 | 150 | 400 | 1 | 8 | O | 5.2 |
| Example 42 | 140 | 6 | 40 | 110 | 150 | 400 | 5 | 7 | O | 5.5 |
| Example 43 | 140 | 6 | 40 | 110 | 150 | 400 | 10 | 5 | O | 5.4 |
| Example 44 | 140 | 6 | 40 | 110 | 150 | 400 | 15 | 5 | O | 5.5 |
| Example 45 | 140 | 6 | 40 | 110 | 150 | 100 | 5 | 9 | O | 5.0 |
| Example 46 | 140 | 6 | 40 | 110 | 150 | 300 | 5 | 8 | O | 5.1 |
| Comparative Example 21 | 140 | 6 | 40 | - | - | - | - | 12 | O | 4.3 |
| Comparative Example 22 | 180 | 6 | 40 | - | - | - | - | 5 | X | - |

## INDUSTRIAL APPLICABILITY

According to the method for producing a lithographic printing plate precursor of the invention, the development property can be improved without degradation of the printing durability, in particular, the on-press development property of a lithographic printing pate precursor which enables removing an unexposed area of the image-recording layer with at least any of ink and dampening water on a printing machine can be improved, and it can be favorably used in various printing fields.

Although the invention has been described in detail and by reference to specific embodiments, it is apparent to those skilled in the art that it is possible to add various alterations and modifications insofar as the alterations and modifications do not deviate from the spirit and the scope of the invention.

The present application is based on a Japanese patent application filed on September 29, 2009 (Japanese Patent Application No. 2009-225552), and the contents thereof are incorporated herein by reference.

## DESCRIPTION OF REFERENCE NUMERALS AND SIGNS

| | |
|---|---|
| 10 | Production line of lithographic printing plate precursor |
| 12 | Unwinder |
| 14 | Support |
| 14A | Lithographic printing plate precursor |
| 16 | Surface treatment unit |
| 18 | Backcoat layer coating and drying unit |
| 20 | Undercoat coating and drying unit |
| 22 | Image-recording layer coating unit |
| 24 | Image-recording layer drying unit |
| 24a | First drying unit |
| 24b | Second drying unit |
| 26 | Overcoat layer coating and drying unit |
| 28 | Cooling unit |
| 30 | Humidifying unit |
| 32 | Rewinder |
| 40 | Drying apparatus |
| 42 | Drying box |
| 44 | Pass roller |
| 46 | Nozzle |
| 48 | Hot air generator |
| 50 | Nozzle |

52 Superheated vapor generator

S Superheated vapor

## Claims

1. A method for producing a polymerizable lithographic printing plate precursor comprising (a) a step of coating a coating solution of an image-recording layer containing (A) a sensitizing dye, (B) a radical polymerization initiator and (C) a radical polymerizable compound onto a support, (b) a first drying step of supplying hot air to the image-recording layer, (c) a second drying step of supplying hot air and superheated vapor to the image-recording layer after the first drying step, (d) a step of coating an overcoat layer onto the image-recording layer, and (e) a step of drying the overcoat layer.

2. The method for producing a lithographic printing plate precursor as claimed in Claim 1, wherein a supplying time of the superheated vapor is from 0.25 to 15 seconds.

3. The method for producing a lithographic printing plate precursor as claimed in Claim 1 or 2, wherein a supplying amount of the superheated vapor is from 50 to 500 $g/m^3$.

4. The method for producing a lithographic printing plate precursor as claimed in Claim 3, wherein a supplying amount of the superheated vapor is from 100 to 400 $g/m^3$.

5. The method for producing a lithographic printing plate precursor as claimed in any one of Claims 1 to 4, wherein when surface temperature of the image-recording layer is T (°C), an amount H ($g/m^3$) of the superheated vapor supplied complies with formula: H < 0.016 x T ^ 2.2 (wherein ^ represents an exponentiation).

6. The method for producing a lithographic printing plate precursor as claimed in any one of Claims 1 to 5, wherein the image-recording layer is an image-recording layer which is capable of forming an image after image exposure by supplying at least any of printing ink and dampening water on a printing machine to remove an unexposed area.

7. The method for producing a lithographic printing plate precursor as claimed in any one of Claims 1 to 6, wherein the overcoat layer contains a water-soluble polymer.

8. The method for producing a lithographic printing plate precursor as claimed in Claim 7, wherein the water-soluble polymer in the overcoat layer is polyvinyl alcohol.

9. The method for producing a lithographic printing plate precursor as claimed in any one of Claims 1 to 8, wherein the overcoat layer contains a stratiform compound.

10. The method for producing a lithographic printing plate precursor as claimed in Claim 9, wherein the stratiform compound in the overcoat layer is mica.

FIG. 1

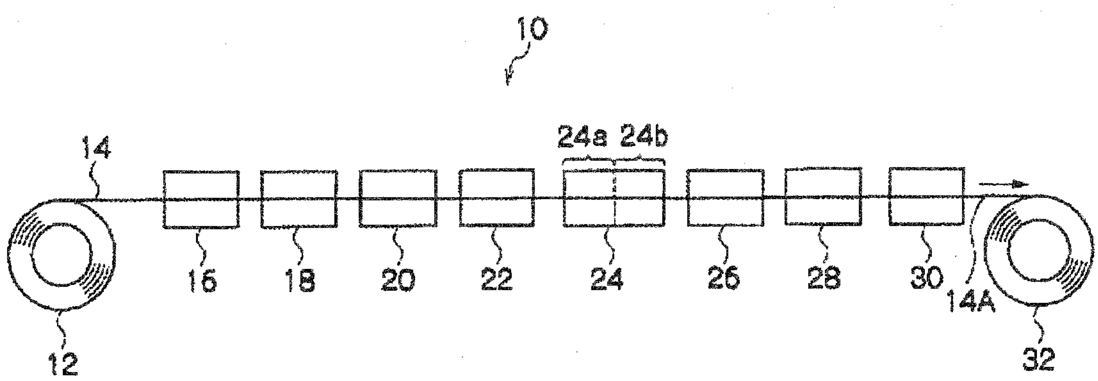
10
14
24a 24b
16
18
20
22
24
26
28
30
14A
12
32

FIG. 2

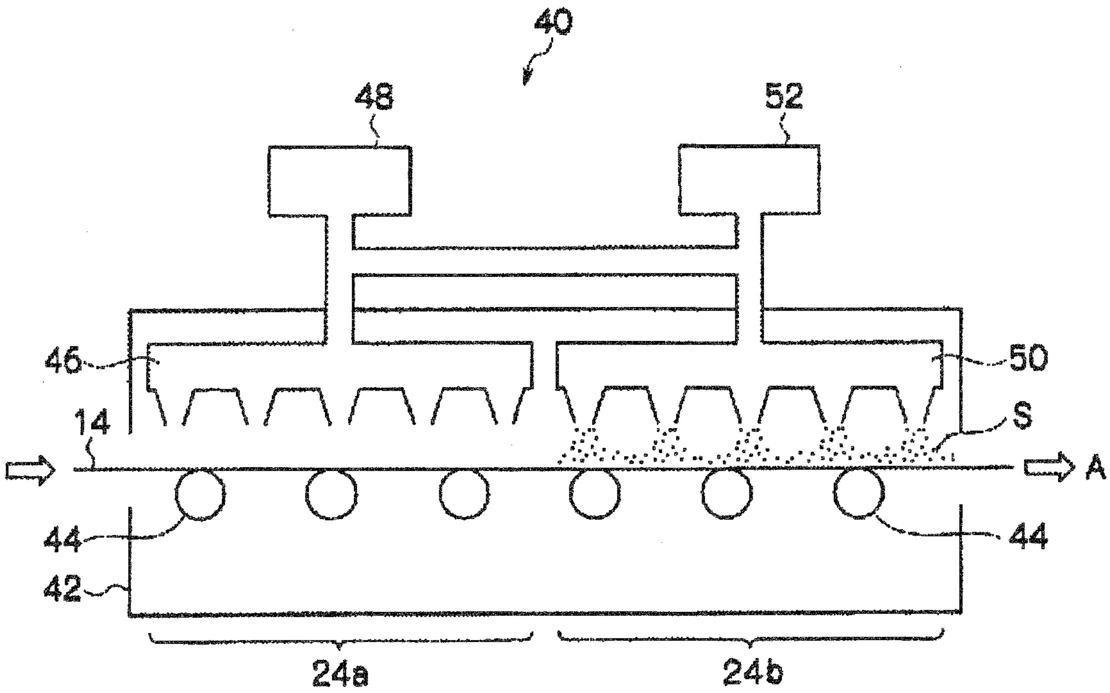
40
48
52
46
50
14
S
A
44
44
42
24a
24b

**INTERNATIONAL SEARCH REPORT**

International application No.
PCT/JP2010/062646

A. CLASSIFICATION OF SUBJECT MATTER
*B41N1/14*(2006.01)i, *G03F7/00*(2006.01)i, *G03F7/11*(2006.01)i

According to International Patent Classification (IPC) or to both national classification and IPC

B. FIELDS SEARCHED

Minimum documentation searched (classification system followed by classification symbols)
B41N1/14, G03F7/00, G03F7/11

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2009/63824 A1 (Fujifilm Corp.),<br>22 May 2009 (22.05.2009),<br>claims; paragraphs [0043] to [0060], [0086], [0225] to [0255]; examples; fig. 2<br>(Family: none) | 1-6<br>7-10 |
| Y | JP 2009-86343 A (Fujifilm Corp.),<br>23 April 2009 (23.04.2009),<br>claims; paragraphs [0041] to [0046]<br>& US 2009/0087778 A1 & EP 2042926 A2<br>& CN 101408730 A | 7-10 |

☐ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 01 October, 2010 (01.10.10) | 12 October, 2010 (12.10.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 9502252 T
- JP 2002333275 A
- JP 2000516334 T
- JP 2002367950 A
- JP 2000158814 A
- JP 2009086343 A
- JP 2008195018 A
- JP 2007058170 A
- JP 2007171406 A
- JP 2007206216 A
- JP 2007206217 A
- JP 2007225701 A
- JP 2007225702 A
- JP 2007316582 A
- JP 2007328243 A
- JP 2001133969 A
- JP 2002023360 A
- JP 2002040638 A
- JP 8108621 A
- JP 61166544 A
- JP 2002328465 A
- US 4069055 A
- JP 4365049 A
- US 4069056 A
- EP 104143 A
- US 20080311520 A
- JP 2150848 A
- EP 370693 A
- EP 390214 A
- EP 233567 A
- EP 297443 A
- EP 297442 A
- US 4933377 A
- US 4760013 A
- US 4734444 A
- US 2833827 A
- DE 2904626
- DE 3604580
- DE 3604581
- JP 2005329708 A
- JP 9123387 A
- JP 9131850 A
- JP 9171249 A
- JP 9171250 A
- EP 931647 A
- JP 2001277740 A
- JP 2001277742 A
- JP 2006297907 A
- JP 2007050660 A
- JP 2008284817 A
- JP 2006091479 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP 6035174 A
- JP 10282679 A
- JP 2304441 A
- JP 2005125749 A
- JP 2006188038 A
- JP 2008203359 A
- JP 2008276166 A
- JP 2009225552 A


### Non-patent literature cited in the description


- **VRENTAS et al.** *J. Appl. Polym. Sci.,* 1985, vol. 30, 4499
- **J. V. CRIVELLO et al.** *Macromolecules,* 1977, vol. 10 (6), 1307
- **J. V. CRIVELLO et al.** *J. Polymer Sci., Polymer Chem. Ed.,* 1979, vol. 17, 1047
- **C. S. WEN et al.** *Teh, Proc. Conf. Rad. Curing ASIA,* October 1988, 478
- *Research Disclosure, No. 333003,* January 1992
- Aluminum Handbook. Japan Light Metal Association, 1990